(19) Europäisches Patentamt
European Patent Office
Office européen des brevets

(11) **EP 3 276 833 A1**

(12) **DEMANDE DE BREVET EUROPEEN**

(43) Date de publication:
**31.01.2018 Bulletin 2018/05**

(51) Int Cl.:
***H03M 3/00*** *(2006.01)*

(21) Numéro de dépôt: **17180146.7**

(22) Date de dépôt: **06.07.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **27.07.2016 FR 1657231**

(71) Demandeur: **Commissariat à l'Energie Atomique et aux Energies Alternatives
75015 Paris (FR)**

(72) Inventeurs:
• **VERDANT, Arnaud
38330 SAINT-NAZAIRE-LES-EYMES (FR)**
• **GUICQUERO, William
91440 BURES-SUR-YVETTE (FR)**

(74) Mandataire: **Thibon, Laurent
Cabinet Beaumont
1, rue Champollion
38000 Grenoble (FR)**

(54) **CONVERTISSEUR SIGMA-DELTA À HAUTE LINÉARITÉ**

(57) L'invention concerne un convertisseur sigma-delta comportant un modulateur sigma-delta comportant au moins un filtre analogique adapté, à chaque cycle d'une phase de conversion, à recevoir un signal analogique interne issu du signal analogique d'entrée et à fournir une valeur analogique de sortie, dans lequel : la contribution du signal analogique interne à la valeur de sortie du filtre est plus faible à un cycle (k) donné de la phase de conversion qu'à un cycle précédent (k-1), les contributions aux différents cycles étant régies par une première loi (f(k)) prédéterminée fonction du rang (k) du cycle ; et la durée d'un cycle (k) donné de la phase de conversion est inférieure à la durée d'un cycle précédent (k-1), les durées des différents cycles étant régies par une deuxième loi (Tc(k)) prédéterminée fonction du rang (k) du cycle dans la phase de conversion.

Fig 17

**Description**

Domaine

La présente demande concerne le domaine des convertisseurs analogique-numérique, et, plus particulièrement, des convertisseurs sigma-delta.

Exposé de l'art antérieur

Un convertisseur sigma-delta comprend typiquement un modulateur sigma-delta et un filtre numérique. Le signal analogique à numériser est appliqué en entrée du modulateur, et est échantillonné par ce dernier à une fréquence relativement élevée (par rapport à la fréquence maximale du signal d'entrée), appelée fréquence de sur-échantillonnage. Le modulateur produit, à la fréquence de sur-échantillonnage, des échantillons binaires représentatifs du signal analogique d'entrée. Le train de bits de sortie du modulateur sigma-delta est traité par le filtre numérique qui en extrait une valeur numérique sur N-bits (N étant la résolution de quantification du convertisseur sigma-delta), représentative du signal d'entrée. Le nombre d'échantillons binaires (c'est-à-dire le nombre de périodes de sur-échantillonnage) nécessaires pour produire une valeur numérique de sortie sur N-bits est désigné par l'acronyme OSR, de l'anglais "Over Sampling Ratio" (taux de sur-échantillonnage).

Le modulateur sigma-delta est typiquement constitué d'une boucle comportant au moins un circuit analogique d'intégration, un convertisseur analogique-numérique 1-bit, un convertisseur numérique-analogique 1-bit, et un soustracteur. Le signal analogique d'entrée est appliqué en entrée du circuit d'intégration, qui l'échantillonne à la fréquence de sur-échantillonnage et fournit à cette même fréquence des échantillons analogiques représentatifs de la différence entre le signal d'entrée et un signal analogique de rétroaction. Les échantillons analogiques de sortie du circuit d'intégration sont numérisés par le convertisseur analogique-numérique 1-bit (typiquement un comparateur). Les échantillons binaires ainsi obtenus forment le signal de sortie du modulateur. Ces échantillons binaires sont par ailleurs convertis en échantillons analogiques par le convertisseur numérique-analogique 1-bit, le signal analogique ainsi obtenu formant le signal de rétroaction du modulateur. Le circuit d'intégration analogique peut comprendre un unique intégrateur analogique, ou plusieurs intégrateurs analogiques cascadés. Il peut aussi comprendre un ou plusieurs soustracteurs, un ou plusieurs sommateurs, et/ou un ou plusieurs coefficients de pondération. Le nombre p d'intégrateurs analogiques définit généralement l'ordre du modulateur sigma-delta. Plus l'ordre p du modulateur est élevé, plus le nombre OSR d'échantillons nécessaires à l'obtention d'une valeur numérique de sortie sur N-bits peut être réduit (à niveaux de bruit de quantification identiques). En contrepartie, les modulateurs sigma-delta sont d'autant plus complexes à réaliser que leur ordre est élevé (stabilisation délicate).

Le filtre numérique comprend, selon la structure du modulateur, un ou plusieurs intégrateurs numériques (généralement au moins autant que d'intégrateurs analogiques dans le modulateur), par exemple des compteurs, et réalise une fonction de filtrage destinée à extraire l'information utile du train de bits produit par le modulateur sigma-delta. Plus particulièrement, le modulateur sigma-delta met en forme le signal utile par l'intermédiaire de sa fonction de transfert de signal STF, et le bruit de quantification par l'intermédiaire de sa fonction de transfert de bruit NTF. La STF est la fonction de transfert liant le signal analogique d'entrée à numériser au signal de sortie du modulateur, et la NTF est la fonction de transfert liant le bruit de quantification introduit par le convertisseur analogique-numérique 1-bit du modulateur au signal de sortie du modulateur. La NTF permet de repousser le bruit de quantification en dehors de la bande d'intérêt (dans laquelle se trouve le signal). Le filtre numérique est conçu de manière à extraire le signal dans les bandes de fréquence où l'atténuation du bruit de quantification par la NTF est élevée (c'est-à-dire là où se trouve le signal). La fonction de transfert de signal STF est généralement égale à 1, et la fonction de transfert de bruit NTF s'exprime par exemple, pour un modulateur d'ordre p, par $NTF(z)=(1-z^{-1})p$.

Il existe un besoin d'améliorer au moins en partie certains aspects des convertisseurs sigma-delta existants.

Résumé

Ainsi, un mode de réalisation prévoit un convertisseur sigma-delta adapté à mettre en oeuvre une phase de conversion d'un signal analogique d'entrée en une valeur numérique de sortie, la phase de conversion comportant une pluralité de cycles de fonctionnement, le convertisseur comportant un modulateur sigma-delta comportant au moins un filtre analogique adapté, à chaque cycle de la phase de conversion, à recevoir un signal analogique interne issu du signal analogique d'entrée et à fournir une valeur analogique de sortie, dans lequel : la contribution du signal analogique interne à la valeur de sortie du filtre analogique est plus faible à un cycle donné de la phase de conversion qu'à un cycle précédent de la phase de conversion, les contributions aux différents cycles étant régies par une première loi prédéterminée fonction du rang du cycle dans la phase de conversion ; et la durée d'un cycle donné de la phase de conversion est inférieure à la durée d'un cycle précédent de la phase de conversion, les durées des différents cycles étant régies par une deuxième loi prédéterminée fonction du rang du cycle dans la phase de conversion.

Selon un mode de réalisation, la deuxième loi est décroissante sur toute la durée de la phase de conversion.

Selon un mode de réalisation, la deuxième loi est décroissante par paliers.

Selon un mode de réalisation, le filtre analogique comprend au moins une capacité d'intégration de valeur réglable.

Selon un mode de réalisation, pendant la phase de conversion, la valeur de la capacité d'intégration varie proportionnellement à la durée des cycles.

Selon un mode de réalisation, le modulateur comporte plusieurs filtres analogiques.

Selon un mode de réalisation, les filtres analogiques forment plusieurs chaines d'un ou plusieurs filtres cascadés, les sorties desdites chaines étant combinées pour générer un signal de sortie du modulateur.

Selon un mode de réalisation, le convertisseur comprend un unique convertisseur analogique-numérique 1-bit.

Selon un mode de réalisation, le convertisseur comprend en entrée du filtre un dispositif de pondération du signal analogique interne reçu par le filtre analogique appliquant un coefficient de pondération variable $\beta_k$, fonction du rang k du cycle et dans lequel, durant la phase de conversion, au moins deux coefficients distincts $\beta_{k-1}$ et $\beta_k$ sont appliqués, respectivement pour deux cycles successifs de rang k-1 et k, et dans lequel $\beta_{k-1} > \beta_k$.

Selon un mode de réalisation, le coefficient de pondération variable $\beta_k$ est décroissant avec le rang k du cycle.

Selon un mode de réalisation, le filtre analogique est équivalent à un circuit théorique comprenant un sommateur entre la valeur d'un signal analogique reçu au cycle k et un signal interne du filtre correspondant à une multiplication par un coefficient $1+\alpha$ du signal de sortie du filtre analogique obtenu au cycle k-1, et dans lequel, durant la phase de conversion, au moins une valeur du coefficient $\alpha$ supérieure strictement à zéro est appliquée pour au moins un cycle.

Selon un mode de réalisation, le coefficient $\alpha$ est croissant avec le rang k du cycle.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1A et 1B illustrent, sous forme de blocs, un exemple d'un convertisseur sigma-delta ;
la figure 2 est un schéma électrique détaillé d'un exemple de réalisation du modulateur sigma-delta de la figure 1A ;
la figure 3 est un chronogramme illustrant l'évolution, en fonction du temps, de signaux de commande du modulateur de la figure 2 ;
la figure 4 est un diagramme illustrant l'évolution de la linéarité et du bruit, en fonction de l'OSR, dans un convertisseur sigma-delta du type décrit en relation avec les figures 1 à 3 ;
les figures 5A et 5B illustrent, sous forme de blocs, un autre exemple de réalisation d'un convertisseur sigma-delta ;
la figure 6 est un diagramme illustrant l'évolution de la linéarité et du bruit, en fonction de l'OSR, dans un convertisseur sigma-delta du type décrit en relation avec les figures 5A et 5B ;
la figure 7 est un diagramme illustrant l'évolution de la linéarité et du bruit, en fonction de l'OSR, dans un autre exemple de convertisseur sigma-delta du type décrit en relation avec les figures 5A et 5B ;
la figure 8 est un diagramme illustrant l'évolution de la linéarité et du bruit, en fonction de l'OSR, dans un autre exemple de convertisseur sigma-delta du type décrit en relation avec les figures 5A et 5B ;
la figure 9 illustre, sous forme de blocs, un autre exemple de réalisation d'un convertisseur sigma-delta ;
la figure 10 illustre, sous forme de blocs, un autre exemple de réalisation d'un convertisseur sigma-delta ;
la figure 11 est un diagramme illustrant le comportement du convertisseur sigma-delta de la figure 10 ;
la figure 12 est un schéma électrique d'un exemple de réalisation d'un circuit permettant de faire varier dynamiquement un coefficient de pondération d'un modulateur sigma-delta ;
la figure 13 illustre, sous forme de blocs, un autre exemple de réalisation d'un convertisseur sigma-delta d'ordre 1 ;
la figure 14 illustre un exemple de réalisation d'un filtre analogique pouvant être mis en oeuvre dans l'exemple de réalisation de la figure 13 ;
les figures 15a et 15b illustrent sous forme d'un chronogramme l'évolution, en fonction du temps, de coefficients appliqués au modulateur du convertisseur de la figure 13 ;
la figure 16 illustre sous forme de blocs, une généralisation de l'exemple de la figure 13 à des convertisseurs d'ordre supérieur à 1 ;
la figure 17 illustre schématiquement le fonctionnement d'un convertisseur sigma-delta selon un exemple d'un mode de réalisation ;
la figure 18 illustre sous forme de blocs un exemple de réalisation d'un convertisseur sigma-delta d'ordre 1 ;
la figure 19 illustre un exemple de réalisation d'un filtre analogique pouvant être mis en oeuvre dans un convertisseur sigma-delta selon un mode de réalisation ;
la figure 20 illustre sous forme de blocs une généralisation de l'exemple de la figure 19 à des convertisseurs d'ordre supérieur à 1 ; et

la figure 21 est un schéma électrique détaillé d'un exemple de réalisation du modulateur sigma-delta du convertisseur de la figure 20.

Description détaillée

De mêmes éléments ont été désignés par de mêmes références aux différentes figures. Par souci de clarté, seuls les éléments utiles à la compréhension des modes de réalisation décrits ont été représentés et sont détaillés. En particulier, les détails de réalisation des filtres numériques des convertisseurs sigma-delta décrits n'ont pas été représentés, la réalisation de ces filtres étant à la portée de l'homme du métier à la lecture de la présente description.

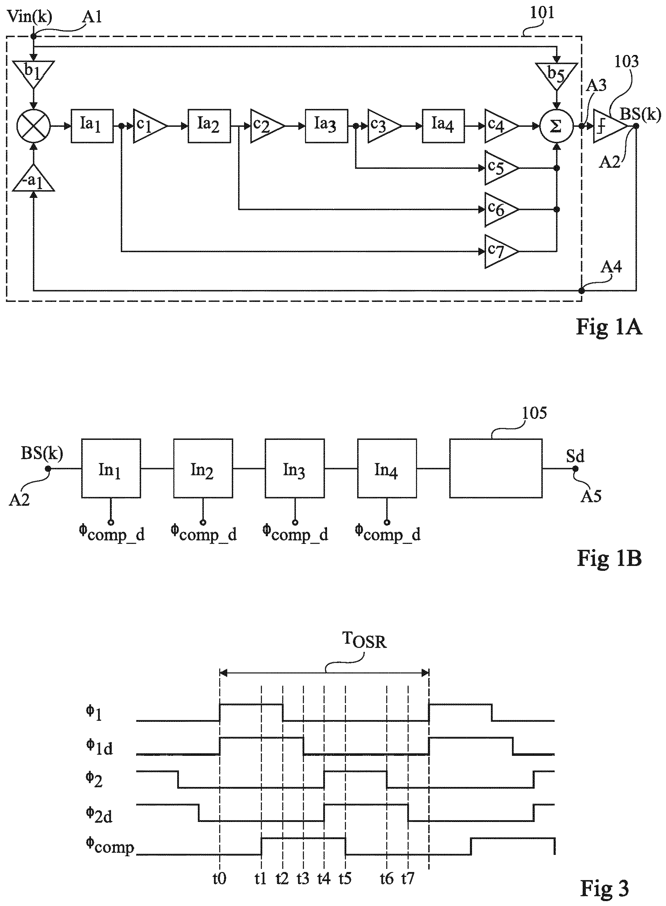

Les figures 1A et 1B illustrent, sous forme de blocs, un exemple d'un convertisseur sigma-delta d'ordre 4. Plus particulièrement, la figure 1A représente le modulateur sigma-delta du convertisseur, et la figure 1B représente le filtre numérique du convertisseur.

Le modulateur sigma-delta de la figure 1A comprend une borne d'entrée A1 destinée à recevoir un signal analogique d'entrée Vin à numériser, et une borne de sortie A2 destinée à fournir une suite d'échantillons binaire BS représentative du signal Vin. Par souci de simplification, on considère ici que le signal analogique d'entrée à numériser est constant pendant toute la durée nécessaire à la production d'une valeur de sortie numérique sur N-bits, soit $OSR*T_{OSR}$, $T_{OSR}$ étant la période de sur-échantillonnage du convertisseur. Les modes de réalisation décrits ci-après ne se limitent toutefois pas à ce cas particulier et peuvent être adaptés à la conversion de signaux analogiques variables.

Le modulateur de la figure 1A comprend un circuit analogique d'intégration 101 comprenant une première entrée connectée à la borne A1 d'application du signal Vin, et une sortie A3 reliée à l'entrée d'un circuit de conversion analogique-numérique 1-bit 103, par exemple un comparateur 1-bit. La sortie du convertisseur 103 est connectée à la sortie A2 du modulateur, et est en outre reliée par une boucle de rétroaction à une deuxième entrée A4 du circuit d'intégration 101. Dans l'exemple représenté, on considère que le signal d'entrée Vin et le signal de sortie BS du modulateur sont normalisés, c'est-à-dire que la valeur 0 du signal binaire BS correspond à un niveau de tension égal à la plus petite valeur que peut prendre le signal analogique Vin, et que la valeur 1 du signal BS correspond à un niveau de tension égal à la plus grande valeur que peut prendre le signal Vin. Ainsi, dans l'exemple représenté, la boucle de rétroaction est une simple piste conductrice reliant la borne A2 à la borne A4, et le signal de rétroaction est directement le signal BS. Dans le cas où le signal binaire de sortie BS n'est pas à la même échelle que le signal d'entrée Vin, la boucle de rétroaction peut comporter un convertisseur numérique-analogique 1-bit entre les bornes A2 et A4, le signal de rétroaction étant alors le signal de sortie du convertisseur numérique-analogique 1-bit.

A chaque cycle k de durée $T_{OSR}$ d'une phase de conversion du signal d'entrée Vin en une valeur numérique, avec k entier allant de 1 à OSR, le circuit d'intégration 101 prélève un échantillon analogique Vin(k) du signal d'entrée, et le modulateur fournit, en sortie du convertisseur analogique-numérique 1-bit 103, un échantillon binaire BS(k) du signal de sortie.

Dans l'exemple de la figure 1A, le circuit d'intégration 101 comporte quatre intégrateurs analogiques cascadés $Ia_1$, $Ia_2$, $Ia_3$ et $Ia_4$, et un circuit de sommation $\Sigma$. Chaque intégrateur comporte une entrée et une sortie, et a par exemple une fonction de transfert en $z/(z-1)$, c'est-à-dire que, à chaque cycle, le signal intégré, ou signal de sortie de l'intégrateur, est augmenté de la valeur du signal appliqué en entrée de l'intégrateur.

Dans l'exemple représenté, l'intégrateur $Ia_1$ reçoit sur son entrée un signal égal à la différence entre le signal d'entrée Vin(k) pondéré par un coefficient $b_1$, et le signal de rétroaction BS(k-1) pondéré par un coefficient $a_1$. L'intégrateur $Ia_2$ reçoit sur son entrée un signal égal au signal de sortie de l'intégrateur $Ia_1$ pondéré par un coefficient $c_1$. L'intégrateur $Ia_3$ reçoit sur son entrée un signal égal au signal de sortie de l'intégrateur $Ia_2$ pondéré par un coefficient $c_2$. L'intégrateur $Ia_4$ reçoit sur son entrée un signal égal au signal de sortie de l'intégrateur $Ia_3$ pondéré par un coefficient $c_3$. Le circuit de sommation additionne le signal d'entrée Vin(k) pondéré par un coefficient $b_5$, et les signaux de sortie des intégrateurs $Ia_1$, $Ia_2$, $Ia_3$ et $Ia_4$, pondérés respectivement par des coefficients $c_7$, $c_6$, $c_5$ et $c_4$. La sortie du circuit de sommation $\Sigma$ est connectée à la borne A3 de sortie du circuit 101.

De nombreuses variantes d'architectures de modulateurs sigma-delta peuvent être envisagées. De façon générale, les modes de réalisation décrits s'appliquent à des modulateurs sigma-delta d'ordre p supérieur ou égal à 1, dans lesquels chacun des p intégrateurs analogiques $Ia_j$, avec j entier allant de 1 à p, reçoit sur son entrée un signal égal à la différence entre le signal d'entrée Vin(k) pondéré par un coefficient bj et le signal de rétroaction BS(k-1) pondéré par un coefficient $a_j$, à laquelle s'additionne, si le rang j de l'intégrateur $Ia_j$ est supérieur à 1, le signal de sortie du modulateur $Ia_{j-1}$ de rang précédant pondéré par un coefficient $c_{j-1}$. Le circuit de sommation $\Sigma$ additionne le signal d'entrée Vin(k) pondéré par un coefficient $b_{p+1}$, le signal de sortie de l'intégrateur $Ia_p$ de rang p pondéré par un coefficient $c_p$, et, si p est supérieur à 1, le ou les signaux de sortie des intégrateurs de rang p-1, avec 1 entier allant de 1 à p-1, pondérés respectivement par des coefficients $c_{p+1}$. Certains des coefficients susmentionnés peuvent être nuls. Par exemple, dans le modulateur d'ordre 4 de la figure 1, les coefficients $b_2$, $b_3$, $b_4$, $a_2$, $a_3$ et $a_4$ sont nuls. On notera que les modes de réalisation décrits peuvent aussi s'appliquer à des modulateurs comportant en outre une ou plusieurs contre-réactions analogiques de la sortie d'un intégrateur analogique vers l'entrée d'un intégrateur analogique amont, au travers d'un coefficient de pondération spécifique, et/ou dans lesquels la sortie d'un intégrateur de rang i est additionnée, au travers d'un coefficient de pondération spécifique, à l'entrée d'un intégrateur aval de rang supérieur ou égal à i+2. En outre, des délais peuvent être introduits entre les différents étages du circuit 101, et/ou entre le circuit 101 et le convertisseur 103.

Le filtre numérique d'un convertisseur sigma-delta comprend généralement un intégrateur numérique, ou plusieurs intégrateurs numériques en cascade. De préférence, un modulateur sigma-delta d'ordre p est associé à un filtre numérique comportant un nombre supérieur ou égal à p d'intégrateurs numériques. Dans l'exemple de la figure 1B, le filtre numérique comprend quatre intégrateurs numériques cascadés $In_1$, $In_2$, $In_3$ et $In_4$. Chaque intégrateur numérique, par exemple un compteur, comporte une entrée et une sortie, et, à chaque cycle, le signal intégré, ou signal de sortie de l'intégrateur, est augmenté de la valeur du signal appliqué en entrée de l'intégrateur. Le premier intégrateur $In_1$ reçoit sur son entrée le signal binaire BS de sortie du modulateur sigma-delta de la figure 1A, le deuxième intégrateur $In_2$ reçoit sur son entrée un signal numérique de sortie de l'intégrateur $In_1$, le troisième intégrateur $In_3$ reçoit sur son entrée un signal numérique de sortie de l'intégrateur $In_2$, et le quatrième intégrateur $In_4$ reçoit sur son entrée un signal numérique de sortie de l'intégrateur $In_3$. Le filtre de la figure 1B réalise une fonction de type passe-bas destinée à extraire l'information utile du train de bits produit par le modulateur sigma-delta. Plus généralement, le filtre numérique extrait le signal aux fréquences où l'atténuation de la NTF est la plus importante. Ainsi, selon la structure du modulateur, le filtre numérique peut réaliser une fonction passe-bas, une fonction passe-bande, ou une fonction passe-haut.

L'intégration numérique est réalisée à la fréquence de sur-échantillonnage du modulateur sigma-delta. Dans l'exemple représenté, les quatre intégrateurs numériques $In_j$ sont commandés simultanément par un même signal de commande $\Phi_{comp\_d}$, de fréquence $1/T_{OSR}$. La sortie du dernier intégrateur numérique $In_4$ est reliée à un bloc de normalisation 105 qui a pour fonction de convertir le signal fourni par l'intégrateur $In_4$ en un code numérique sur N-bits, N étant un entier supérieur à 1 correspondant à la résolution du convertisseur sigma-delta. A titre d'exemple, le bloc 105 divise le signal qu'il reçoit par une valeur de référence, par exemple égale à la valeur que prendrait ce signal pour la valeur maximale autorisée du signal Vin, et fournit sur une borne de sortie A5 du convertisseur une valeur de sortie $S_d$ représentative du résultat de la division quantifiée sur N-bits.

Diverses variantes d'architectures de filtres numériques peuvent être envisagées. En particulier, la topologie du filtre numérique peut être modifiée pour se rapprocher de celle du modulateur sigma-delta. Par exemple, au lieu de recevoir sur son entrée uniquement le signal de sortie du dernier intégrateur numérique $In_4$ comme dans l'exemple de la figure 1B, le circuit de normalisation 105 peut recevoir un signal égal à la somme des signaux de sortie des quatre intégrateurs $In_1$, $In_2$, $In_3$ et $In_4$. En outre, pour se rapprocher encore davantage de la topologie du modulateur sigma-delta, les signaux numériques internes du filtre numérique peuvent être pondérés par des coefficients identiques à ceux du modulateur.

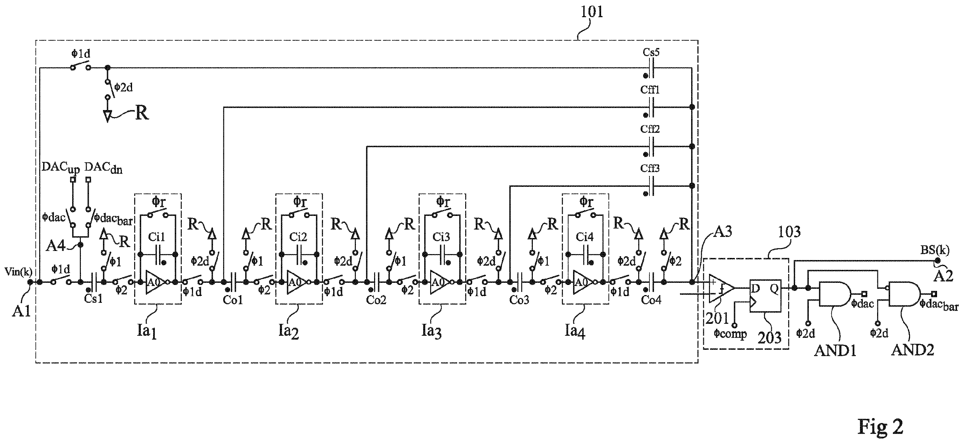

La figure 2 est un schéma électrique détaillé illustrant un exemple (non limitatif) de réalisation du modulateur sigma-delta de la figure 1A.

Dans l'exemple de la figure 2, chaque intégrateur $Ia_j$ comprend un amplificateur opérationnel AO dont l'entrée est reliée à la sortie par une capacité d'intégration Cij. L'entrée et la sortie de l'amplificateur opérationnel forment respectivement l'entrée et la sortie de l'intégrateur. Chaque intégrateur $Ia_j$ comprend en outre, en parallèle de sa capacité d'intégration Cij, un interrupteur de réinitialisation commandé par un signal Φr. Dans la suite de la description, par souci de simplification, les interrupteurs du modulateur sont désignés par les mêmes références que leurs signaux de commande respectifs.

Les sorties des intégrateurs $Ia_1$, $Ia_2$, $Ia_3$ et $Ia_4$ sont reliées respectivement à une première électrode d'une capacité Co1, à une première électrode d'une capacité Co2, à une première électrode d'une capacité Co3 et à une première électrode d'une capacité Co4, par des premier, deuxième, troisième et quatrième interrupteurs Φ1d. Par ailleurs, les premières électrodes des capacités Co1, Co2, Co3 et Co4 sont reliées à un noeud R d'application d'un potentiel de référence, par exemple égal au potentiel moyen entre la valeur de sortie haute $DAC_{up}$ et la valeur de sortie basse $DAC_{dn}$ du convertisseur numérique-analogique de contre-réaction, respectivement par des premier, deuxième, troisième et quatrième interrupteurs Φ2d. Les deuxièmes électrodes des capacités Co1, Co2 et Co3 sont reliées au noeud R respectivement par des premier, deuxième et troisième interrupteurs Φ1. De plus, les deuxièmes électrodes des capacités Co1, Co2 et Co3 sont reliées respectivement à l'entrée de l'intégrateur $Ia_2$, à l'entrée de l'intégrateur $Ia_3$, et à l'entrée de l'intégrateur $Ia_4$, par des premier, deuxième et troisième interrupteurs Φ2. La deuxième électrode de la capacité Co4 est reliée au noeud R par un quatrième interrupteur Φ2, et est en outre connectée à l'entrée A3 du convertisseur analogique-numérique 103.

Le modulateur de la figure 2 comprend en outre une capacité Cs1 dont une première électrode est reliée à la borne A1 d'application du signal d'entrée Vin par un cinquième interrupteur Φ1d, et dont la deuxième électrode est reliée à l'entrée de l'intégrateur $Ia_1$ par un cinquième interrupteur Φ2. La deuxième électrode de la capacité Cs1 est en outre reliée au noeud R par un quatrième interrupteur Φ1. Par ailleurs, la première électrode de la capacité Cs1 est reliée à un noeud d'application d'un potentiel DACup par un interrupteur Φdac, et à un noeud d'application d'un potentiel DACdn inférieur au potentiel DACup par un interrupteur $\Phi dac_{bar}$.

**EP 3 276 833 A1**

La borne A1 d'application du signal d'entrée Vin est en outre reliée à une première électrode d'une capacité Cs5 par un sixième interrupteur Φ1d. La première électrode de la capacité Cs5 est en outre reliée au noeud R par un cinquième interrupteur Φ2d. La deuxième électrode de la capacité Cs5 est connectée au noeud d'entrée A3 du convertisseur analogique-numérique 103.

Par ailleurs, les premières électrodes des capacités Co1, Co2 et Co3 sont reliées au noeud d'entrée du convertisseur analogique-numérique 103 respectivement par des capacités Cff1, Cff2 et Cff3.

Dans cet exemple, le convertisseur analogique-numérique 1-bit 103 comprend un comparateur 201 et une bascule 203. L'entrée du comparateur 201 forme l'entrée du convertisseur 103. La sortie du comparateur 201 est connectée à l'entrée de la bascule 203. La sortie de la bascule 203 forme la sortie A2 du convertisseur 103, fournissant le signal de sortie BS du modulateur sigma-delta. En fonctionnement, la sortie du comparateur 201 passe d'un état haut à un état bas selon que le signal appliqué sur la borne A3 est supérieur ou inférieur à un seuil, par exemple égal au potentiel de référence appliqué sur le noeud R. La bascule 203 échantillonne le signal de sortie du comparateur 201 et le recopie sur la sortie du modulateur à chaque front montant ou descendant d'un signal de commande Φcomp.

Le modulateur de la figure 2 comprend en outre deux portes ET AND1 et AND2 comportant chacune deux entrées et une sortie binaires. Les entrées de la porte AND1 sont connectées respectivement à la sortie A2 du convertisseur 103 et au signal de commande Φ2d, et les entrées de la porte AND2 reçoivent respectivement un signal complémentaire du signal de sortie du convertisseur 103 et le signal de commande Φ2d. La sortie de la porte AND1 est connectée à un noeud de commande de l'interrupteur Φdac, et la sortie de la porte AND2 est connectée à un noeud de commande de l'interrupteur Φdac$_{bar}$.

Les intégrateurs Ia$_1$, Ia$_2$, Ia$_3$ et Ia$_4$, les capacités Cs1, Co1, Co2, Co3, Co4, Cs5, Cff1, Cff2 et Cff3, et les interrupteurs Φ1, Φ2, Φ1d et Φ2d forment le circuit analogique d'intégration 101 du modulateur. Les interrupteurs Φdac et Φdac$_{bar}$ et les portes AND1 et AND2 forment le convertisseur numérique-analogique 1-bit de la boucle de rétroaction du modulateur.

La figure 3 est un chronogramme illustrant l'évolution, en fonction du temps, des signaux de commande Φ1, Φ1d, Φ2, Φ2d et Φcomp du modulateur de la figure 2 selon un exemple de procédé de commande de ce modulateur. Plus particulièrement, la figure 3 illustre l'évolution des signaux Φ1, Φ1d, Φ2, Φ2d et Φcomp pendant un cycle T$_{OSR}$ correspondant à une période de sur-échantillonnage du modulateur. A titre d'exemple, l'acquisition d'une valeur numérique sur N-bits représentative du signal d'entrée Vin peut comporter une phase initiale de réinitialisation des intégrateurs analogiques Ia$_1$, Ia$_2$, Ia$_3$ et Ia$_4$, pendant laquelle les interrupteurs Φr sont fermés de façon à décharger les capacités d'intégration Ci1, Ci2, Ci3 et Ci4. A l'issue de cette phase de réinitialisation, les interrupteurs Φr peuvent être ouverts, puis la séquence de commande de durée T$_{OSR}$ illustrée en figure 3 peut être répétée OSR fois (dans le cas d'un convertisseur sigma-delta incrémental réinitialisé entre deux conversions analogique-numérique successives, ou plus de OSR fois s'il ne s'agit pas d'un convertisseur incrémental).

A un instant t0 de début d'un cycle T$_{OSR}$ de commande du modulateur, les interrupteurs Φ1 et Φ1d sont commandés à l'état fermé (signaux de commande correspondant à l'état 1 dans cet exemple), et les interrupteurs Φ2 et Φ2d sont commandés à l'état ouvert (signaux de commande correspondant à l'état 0 dans cet exemple). Ceci conduit à l'échantillonnage du signal d'entrée Vin sur la capacité d'entrée Cs1 de l'intégrateur Ia$_1$, et des signaux de sortie des intégrateurs Ia$_1$, Ia$_2$, Ia$_3$ respectivement sur les capacités d'entrée Co1, Co2 et Co3 des intégrateurs Ia$_1$, Ia$_2$ et Ia$_3$. Les signaux échantillonnés étant des tensions, chaque capacité stocke une quantité de charges proportionnelle au produit de la tension échantillonnée par la valeur de la capacité d'échantillonnage. Pendant cette phase, les signaux stockés dans les capacités Cs5, Cff1, Cff2, Cff3 et Co4 sont sommés sur le noeud de sortie A3 du circuit 101, qui constitue le sommateur ∑ de la figure 1A. On réalise ainsi la sommation pondérée des signaux stockés dans ces capacités, la pondération appliquée résultant des valeurs des capacités.

A un instant t1 postérieur à l'instant t0, le signal Φcomp est mis à l'état haut. Le signal d'entrée du convertisseur analogique-numérique 103 (tension du noeud A3) est quantifié sur un bit par le convertisseur 103 sur le front montant du signal Φcomp. La valeur binaire du signal de sortie BS est ainsi mise à jour.

A un instant t2 postérieur à l'instant t1, le signal Φ1 est mis à l'état bas, et, à un instant t3 postérieur à l'instant t2, le signal Φ1d est mis à l'état bas.

A un instant t4 postérieur à l'instant t3, les signaux Φ2 et Φ2d sont mis à l'état haut. Il en résulte que les valeurs des intégrateurs Ia$_1$, Ia$_2$, Ia$_3$ et Ia$_4$ sont mises à jour, c'est-à-dire que les charges échantillonnées dans les capacités Cs1, Co1, Co2, Co3 sont intégrées dans les capacités Ci1, Ci2, Ci3, Ci4 respectivement. En outre, la contreréaction est activée, c'est-à-dire que le signal DACup ou DACdn (selon que le signal BS est à l'état haut ou bas), est soustrait au signal d'entrée de la capacité Cs1.

A un instant t5, postérieur à l'instant t4 dans cet exemple, le signal Φcomp est remis à l'état bas.

A un instant t6 postérieur à l'instant t4, le signal Φ2 est mis à l'état bas, et, à un instant t7 postérieur à l'instant t6, le signal Φ2d est mis à l'état bas.

Après l'instant t7, le cycle susmentionné peut recommencer.

La quantification est effectuée pendant la phase Φ1 = 1, et l'intégration de la nouvelle contre-réaction est

6

effectuée pendant la phase $\Phi 2 = 1$.

La valeur numérique binaire BS(k) de sortie du modulateur obtenue à chaque cycle $T_{OSR}$ est intégrée par le filtre numérique à la fréquence de sur-échantillonnage du modulateur, par exemple sur les fronts montants du signal $\Phi_{comp\_d}$, qui peut être une copie retardée du signal $\Phi_{comp}$ (d'un retard inférieur à $T_{OSR}$).

Les valeurs des capacités Cs1, Cs5, Co1, Co2, Co3, Co4, Cff1, Cff2, Cff3 fixent les valeurs des coefficients $b_1$, $b_5$, $a_1$, $c_1$, $c_2$, $c_3$, $c_4$, $c_5$, $c_6$, $c_7$ du modulateur, par exemple selon les relations suivantes : Ci1 = $2*Cs1/c_1$ ; Ci2 = $Co1/c_2$ ; Ci3 = $Co2/c_3$ ; Ci4 = $Co3/c_4$ ; Cff1 = $Cs5*(c_7/(c_1*b_5))$ ; Cff2 = $Cs5*(c_6/(c_2*b_5))$ ; Cff3 = $Cs5*(c_5/(c_3*b_5))$ ; et Co4 = $Cs5/b_5$.

Une caractéristique importante d'un convertisseur sigma-delta est sa linéarité. L'erreur de non-linéarité, généralement désignée dans la technique par l'acronyme INL (de l'anglais "Integral Non Linearity"), est la différence maximale (erreur crête à crête), sur la plage de fonctionnement du convertisseur, entre la fonction de transfert du convertisseur (qui fait correspondre à chaque valeur du signal d'entrée analogique un code de sortie numérique), et la fonction de transfert linéaire idéale. L'erreur de linéarité peut être exprimée en LSB (de l'anglais "Least Significant Bit" - bit de poids faible), où 1 LSB = $(Vin_{max}-Vin_{min})/2^N$, $Vin_{max}$ et $Vin_{min}$ étant respectivement la valeur maximale et la valeur minimale du signal analogique d'entrée sur la plage de fonctionnement du convertisseur, et N étant la résolution de quantification du convertisseur. La linéarité L du convertisseur peut être définie par la formule suivante : L = $\log_2((Vin_{max}-Vin_{min})/(INL*LSB))$.

Une autre caractéristique importante d'un convertisseur sigma-delta est son bruit de sortie B, qui peut être défini comme étant la moyenne, sur la plage de fonctionnement $[Vin_{min}, Vin_{max}]$ du convertisseur (sur un nombre de conversions significatif pour chaque point de la dynamique d'entrée), des écarts types des codes numériques de sortie du convertisseur de chaque niveau du signal analogique d'entrée.

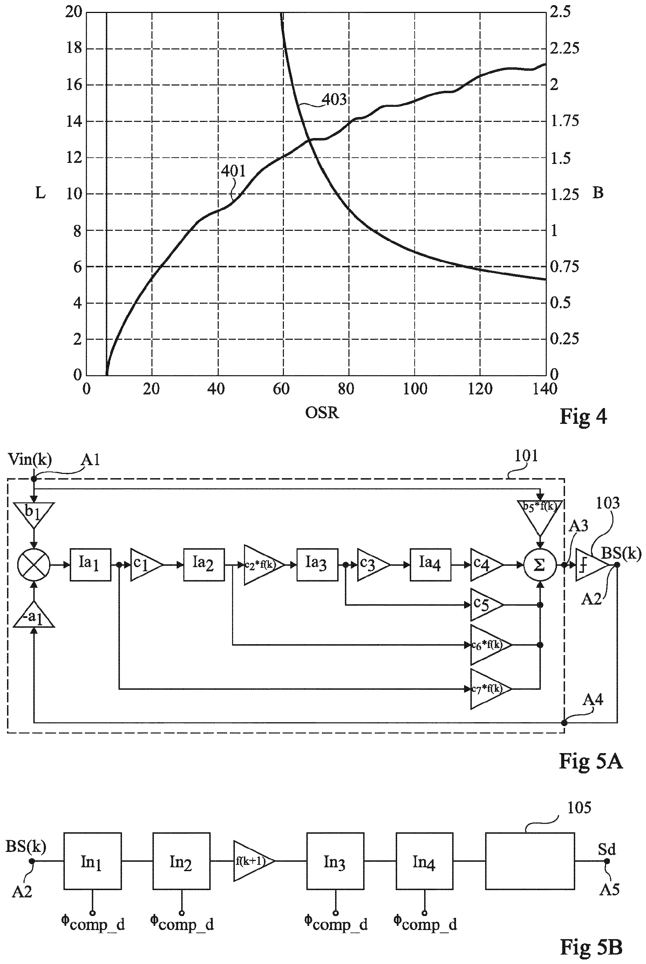

La figure 4 est un diagramme illustrant l'évolution de la linéarité L et du bruit B, en fonction de l'OSR, dans un convertisseur sigma-delta du type décrit en relation avec les figures 1 à 3. Plus particulièrement, la courbe 401 représente l'évolution de la linéarité L (en ordonnée à gauche) en fonction de l'OSR (en abscisse), et la courbe 403 représente l'évolution du bruit B exprimé en LSB (en ordonnée à droite) en fonction de l'OSR. Dans cet exemple, on a considéré un convertisseur sigma-delta effectuant une quantification sur N = 16 bits.

Comme cela apparaît sur la figure 4, plus l'OSR augmente, plus la linéarité L augmente, et plus le bruit B diminue. A titre d'exemple, un OSR égal à 100 permet d'avoir une valeur de linéarité L égale à 15 et un niveau de bruit B égal à 0,85 LSB, alors qu'un OSR égal à 60 ne procure qu'une linéarité L égale à 12 et un niveau de bruit B égal à 2,4 LSB.

Il serait souhaitable de pouvoir améliorer la linéarité d'un convertisseur sigma-delta pour un OSR donné, ou, pour une valeur de linéarité donnée, de pouvoir réduire l'OSR, et ce sans dégrader de façon significative le bruit de sortie du convertisseur.

La solution proposée, qui va maintenant être décrite, est tout particulièrement avantageuse pour des convertisseurs sigma-delta d'ordre supérieur à 1, dans lesquels elle permet d'améliorer de façon significative le compromis OSR/linéarité. Toutefois, cette solution est compatible avec des convertisseurs sigma-delta d'ordre 1, dans lesquels elle permet aussi d'améliorer le compromis OSR/linéarité (et en outre d'augmenter le rapport signal sur bruit par rapport au rapport signal sur bruit induit par le bruit de quantification, par exemple généralement défini par $\log2(((3*OSR^3)/(\pi 2/12))^{1/2})$ dans un modulateur d'ordre 1 sans coefficient variable.

Selon un aspect d'un mode de réalisation, on prévoit un convertisseur sigma-delta dans lequel, pendant l'acquisition d'une valeur numérique sur N-bits représentative du signal analogique d'entrée, au moins un coefficient de pondération du modulateur sigma-delta varie de façon dynamique selon une loi f prédéterminée. De préférence, au moins un signal numérique interne au filtre numérique est en outre pondéré par une loi variable prédéterminée, par exemple mais non nécessairement par la même loi f que celle appliquée dans le modulateur.

Ceci constitue une différence par rapport aux convertisseurs sigma-delta connus, dans lesquels les coefficients de pondération du modulateur sont fixes, et en particulier, restent constants pendant les OSR cycles d'échantillonnage d'une phase de conversion analogique-numérique du signal d'entrée. En outre, dans les convertisseurs sigma-delta connus, aucun signal interne au filtre numérique n'est pondéré par un coefficient variable dynamiquement pendant les OSR cycles d'échantillonnage d'une phase de conversion analogique-numérique du signal d'entrée.

On notera que le coefficient de pondération du modulateur auquel est appliquée la loi f peut par exemple avoir une valeur initiale (avant modulation par la loi f) égale à 1 (à titre d'exemple, un fil de liaison sans coefficient apparent correspond à un coefficient unitaire, et on peut choisir d'appliquer la loi f sur ce coefficient). Les modes de réalisation décrits ne se limitent toutefois pas à ce cas particulier.

Les figures 5A et 5B illustrent, sous forme de blocs, un exemple de réalisation d'un convertisseur sigma-delta. Dans l'exemple représenté, le convertisseur est un convertisseur d'ordre 4. La figure 5A représente le modulateur sigma-delta du convertisseur, et la figure 5B représente le filtre numérique du convertisseur.

Le convertisseur sigma-delta des figures 5A et 5B présente des éléments communs avec le convertisseur sigma-delta des figures 1A et 1B. Ces éléments ne seront pas détaillés à nouveau. Seules les différences entre les deux convertisseurs seront exposées ci-après.

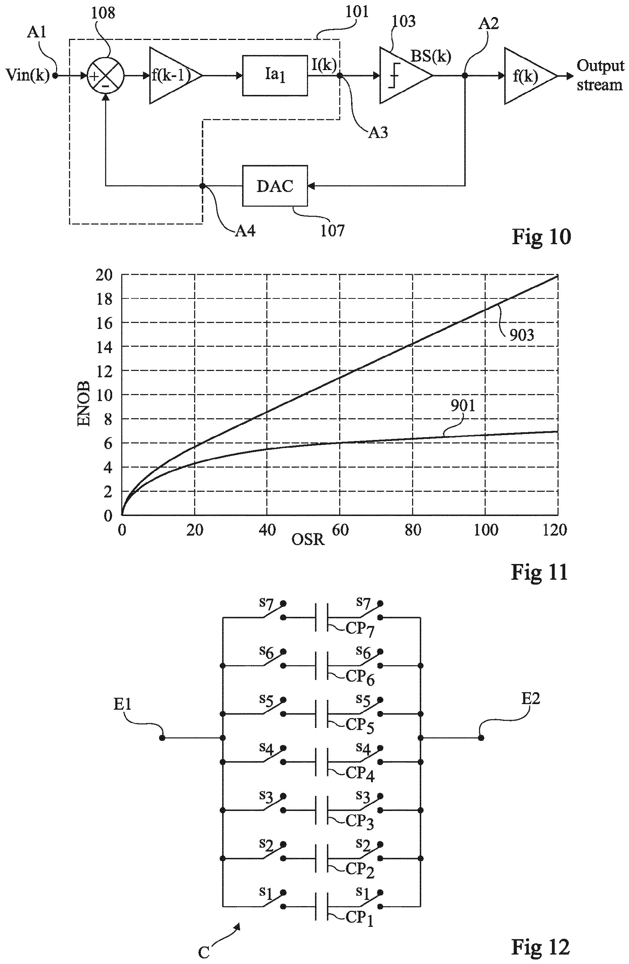

Le modulateur sigma-delta de la figure 5A diffère du modulateur sigma-delta de la figure 1A essentiellement en ce que, dans le modulateur de la figure 5A, les coefficients de pondération $c_2$, $c_6$, $c_7$ et $b_5$ sont modulés par une même loi variable prédéterminée f. A chaque cycle d'échantillonnage k d'une phase de conversion analogique-numérique du signal d'entrée, avec k entier allant de 1 à OSR, la valeur f (k) de la loi f est susceptible de prendre une nouvelle valeur. Ainsi, les coefficients de pondération fixes $c_2$, $c_6$, $c_7$ et $b_5$ du modulateur de la figure 1A sont remplacés par des coefficients variables $c_2$*f(k), $c_6$*f(k), $c_7$*f(k) et $b_5$*f(k). La loi f(k) est de préférence non binaire. Les OSR valeurs f(k) de la loi f sont par exemple stockées dans une mémoire d'un circuit de commande (non représenté) du convertisseur sigma-delta. Un exemple de circuit permettant d'appliquer une loi de pondération variable à des coefficients du modulateur sera décrit plus en détail ci-après en relation avec la figure 12. Les valeurs de base (non modulées par la loi f) des coefficients $c_2$, $c_6$, $c_7$ et $b_5$, de même que les valeurs des coefficients fixes $b_1$, $a_1$, $c_1$, $c_3$, $c_4$ et $c_5$, peuvent être déterminées par les méthodes usuelles de détermination des coefficients d'un modulateur sigma-delta, par exemple selon les règles de dimensionnement décrites dans l'article intitulé "Automatic coefficients design for high-order sigma-delta modulators" de Kuo, T.H., Chen, K.D., et Chen, J.R. (Circuits and Systems II: Analog and Digital Signal Processing, IEEE Transactions, Volume 46, Issue 1), ou dans le document "Understanding Delta-Sigma Data Converters" (John Wiley & Sons, New York, 2004).

Le filtre numérique de la figure 5B diffère du filtre numérique de la figure 1B essentiellement en ce que, dans le filtre de la figure 5B, la loi de pondération variable f appliquée aux coefficients $c_2$, $c_6$, $c_7$ et $b_5$ du modulateur sigma-delta est en outre appliquée au signal numérique d'entrée de l'intégrateur numérique de rang 3 $In_3$. Dans l'exemple représenté, la loi variable f est appliquée au niveau du filtre numérique avec un cycle d'avance par rapport au modulateur, c'est-à-dire que lors d'un cycle d'échantillonnage $T_{OSR}$ du convertisseur sigma-delta, si la valeur de pondération f(k) est appliquée aux coefficients $c_2$, $c_6$, $c_7$ et $b_5$ du modulateur, la valeur de pondération f (k+1) est appliquée au signal d'entrée de l'intégrateur numérique $In_3$. Les inventeurs ont en effet constaté que ce décalage d'un cycle permet d'obtenir des performances particulièrement bonnes en termes de linéarité. Les modes de réalisation décrits ne se limitent toutefois pas à ce cas particulier. A titre de variante, la loi f peut être appliquée en phase au niveau du modulateur et au niveau du filtre numérique, ou avec une avance supérieure à un cycle dans le filtre numérique, ou avec un retard d'un cycle ou plus dans le filtre numérique. Dans une autre variante de réalisation, la loi f peut être appliquée avec un déphasage d'un cycle ou plus sur des coefficients distincts du modulateur, ou sur des signaux distincts du filtre numérique. Par exemple, lors d'un même cycle k d'une phase de conversion analogique-numérique du signal d'entrée, le coefficient a1 du modulateur peut être pondéré par la valeur f(k), et le coefficient b1 par la valeur f(k+1).

Les modes de réalisation décrits ne se limitent pas à l'exemple particulier des figures 5A et 5B, dans lequel le convertisseur sigma-delta est un convertisseur d'ordre 4 et dans lequel la loi de pondération f(k) est appliquée sur les coefficients $c_2$, $c_6$, $c_7$ et $b_5$ du modulateur, et en entrée de l'intégrateur numérique de rang 3 du filtre numérique.

Plus généralement, quel que soit l'ordre du convertisseur, le choix du ou des coefficients du modulateur sur lesquels est appliquée la loi de pondération f(k) est de préférence tel qu'au moins un coefficient d'entrée d'un intégrateur analogique $Ia_j$ du modulateur est modulé par la loi f. De plus, dans un mode de réalisation préféré, au moins un coefficient d'entrée d'un intégrateur numérique $In_k$ du filtre numérique est modulé par la loi f, avec de préférence j=k.

De préférence, on prévoit en outre que les signaux analogiques additionnés ou soustraits dans le modulateur soient à la même échelle vis-à-vis de la loi f(k), c'est-à-dire qu'ils aient été multipliés ou divisés un même nombre de fois (éventuellement nul) par la loi f(k). Autrement dit, une remise à l'échelle permet aux signaux analogiques de varier dans une même plage d'amplitude pour une plage d'amplitude donnée du signal analogique d'entrée (Vin). Le choix du ou des coefficients du modulateur sur lesquels est appliquée la loi de pondération f(k) peut par exemple être effectué de façon que tous les échantillons composant le signal intégré de sortie du circuit analogique d'intégration 101 soient à la même échelle vis-à-vis de la loi f(k). De préférence, on prévoit qu'au moins un coefficient d'entrée d'un intégrateur analogique $Ia_i$ soit modulé par la loi f, et que tous les signaux s'additionnant ou se soustrayant au signal pondéré, que ce soit à l'entrée de l'intégrateur $Ia_i$ ou sur le chemin aval (après la sortie de l'intégrateur $Ia_i$), soient de préférence à la même échelle vis-à-vis de la loi f. Un signal est considéré à l'échelle vis-à-vis de la loi f s'il se situe sur le chemin aval d'un intégrateur ayant un coefficient amont pondéré par la loi f, ou s'il est lui-même directement pondéré par la loi f.

A titre d'exemple, le choix du ou des coefficients du modulateur sur lesquels est appliquée la loi de pondération f(k) est effectué de façon que tous les échantillons composant le signal intégré de sortie du circuit 101 soient multipliés (directement, ou indirectement si l'échantillon est un échantillon de sortie d'un intégrateur ayant un coefficient amont pondéré par la loi f) par la loi f (k) . Cette règle est notamment respectée dans le modulateur de la figure 5A, dans lequel tous les échantillons qui composent les signaux d'entrée du sommateur $\Sigma$ sont multipliés directement ou indirectement par la loi f (k) (directement pour les signaux passant par les coefficients variables $b_5$*f(k), $c_6$*f(k) et $c_7$*f(k), et indirectement pour les signaux passant par les coefficients fixes $c_4$ et $c_5$, dans la mesure où ces signaux sont passés en amont par le coefficient variable $c_2$*f(k)). A titre de variante, et en respectant cette même règle, les coefficients du modulateur sur lesquels est appliquée la loi f(k) peuvent être les coefficients $b_1$, $a_1$ et $b_5$, ou dans une autre variante les coefficients $c_1$, $b_5$ et $c_7$, ou dans une autre variante les coefficients $c_3$, $b_5$, $c_5$, $c_6$ et $c_7$. La pondération du jeu de coefficients c4, c5, c6, c7 et c5 par la loi f est quant à elle moins avantageuse dans la mesure où aucun coefficient amont d'un intégrateur analogique n'est modulé par la loi f.

Au niveau du filtre numérique, la loi de pondération f(k) peut être appliquée sur un signal autre que le signal d'entrée de l'intégrateur numérique de rang 3 $In_3$. Plus généralement et comme dans le modulateur, le choix des signaux numériques auxquels est appliquée la loi f(k) est de préférence effectué de façon à ce que la loi de pondération f(k) soit appliquée en entrée d'au moins un intégrateur numérique, de préférence l'intégrateur de même rang j que l'intégrateur analogique $Ia_j$ en entrée duquel est appliquée la loi f(k) dans le modulateur. De plus, comme dans le modulateur, le choix des signaux numériques auxquels est appliquée la loi f (k) est de préférence effectué de façon à ce que les signaux numériques additionnés ou soustraits dans le filtre numérique soient à la même échelle vis-à-vis de la loi f (k) . De préférence, le filtre numérique comprend un nombre d'intégrateurs numériques cascadés supérieur ou égal (de préférence égal) à l'ordre p du modulateur sigma-delta. De plus, si le filtre numérique présente une topologie similaire à celle du modulateur, la loi f(k) peut être appliquée sensiblement aux mêmes points dans le modulateur et dans le filtre numérique.

A titre de variante, pour respecter la mise à l'échelle des signaux intermédiaires combinés pour former le signal de sortie du circuit analogique d'intégration 101 du modulateur, certains signaux intermédiaires peuvent être multipliés par la loi f(k), et d'autres divisés par la loi f(k). Par exemple, le coefficient $c_2$ peut être multiplié par la loi f(k) et les coefficients $c_4$ et $c_5$ divisés par la loi f (k) de manière à conserver une même échelle au niveau du sommateur, les autres coefficients du modulateur restant constants. Dans ce cas, la pondération par la loi f(k) au niveau du filtre numérique peut être identique à ce qui a été décrit précédemment (multiplication du signal d'entrée de l'intégrateur $In_3$ par la loi f(k)).

Les inventeurs ont constaté que quelle que soit la loi f choisie, et pour autant que la loi f présente au moins une phase de décroissance sur la plage des indices k allant de 1 à OSR, le fait d'appliquer un coefficient de pondération variable à au moins un signal analogique interne du modulateur sigma-delta et avantageusement à au moins un signal numérique interne du filtre numérique permet d'améliorer de façon significative la linéarité du convertisseur sigma-delta (pour un OSR donné). La phase de décroissance est fonction du rang k du cycle. La phase de décroissance génère une contribution au filtre analogique du signal analogique interne à un cycle donné k qui est plus faible que la contribution au filtre analogique du même signal analogique interne au cycle précédent k-1. Au moins une contribution décroissante entre deux cycles de rang successifs apporte déjà un avantage. A titre d'exemple, la loi f peut être une loi décroissante sur toute la plage des indices k allant de 1 à OSR, par exemple une loi exponentielle décroissante. A titre de variante, la loi f peut être une loi constante, par exemple égale à 1, sur la plage des indices k allant de 1 à t, avec t entier compris entre 1 et OSR, et décroissante (par exemple selon une exponentielle) sur la plage des indices k allant de t+1 à OSR.

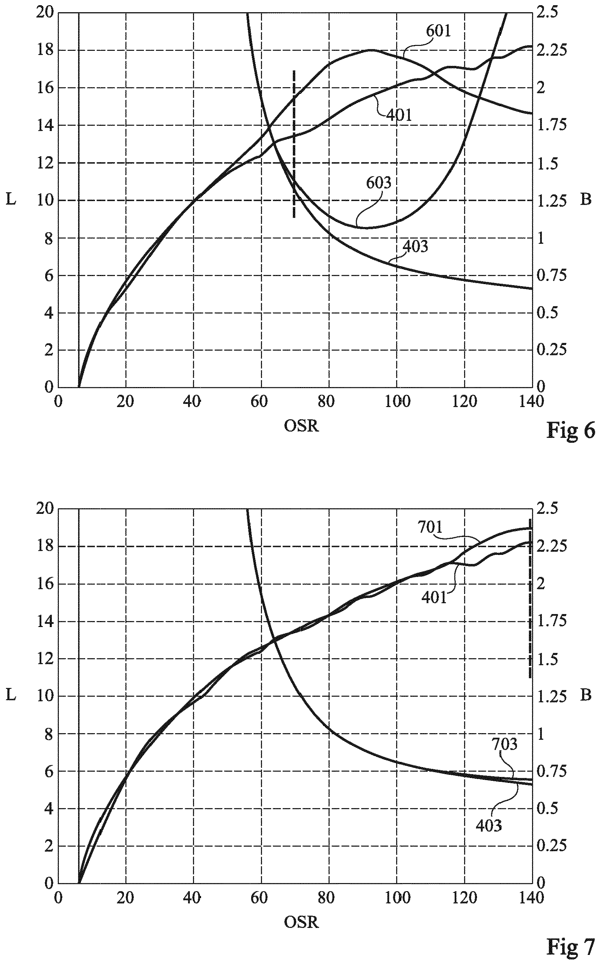

Les figures 6, 7 et 8 sont des diagrammes illustrant, pour trois lois f distinctes, l'évolution de la linéarité L et du bruit B en fonction de l'OSR dans un convertisseur sigma-delta du type décrit en relation avec les figures 5A et 5B.

Dans l'exemple de la figure 6, la loi de pondération dynamique appliquée au convertisseur sigma-delta est donnée par l'équation $f(k) = e^{-k/25}$.

Dans l'exemple de la figure 7, la loi de pondération dynamique appliquée au convertisseur sigma-delta est définie comme suit :

pour k < 100, f(k) = 1 ; et
pour k >= 100, $f(k) = e^{-(k-100)/20}$.

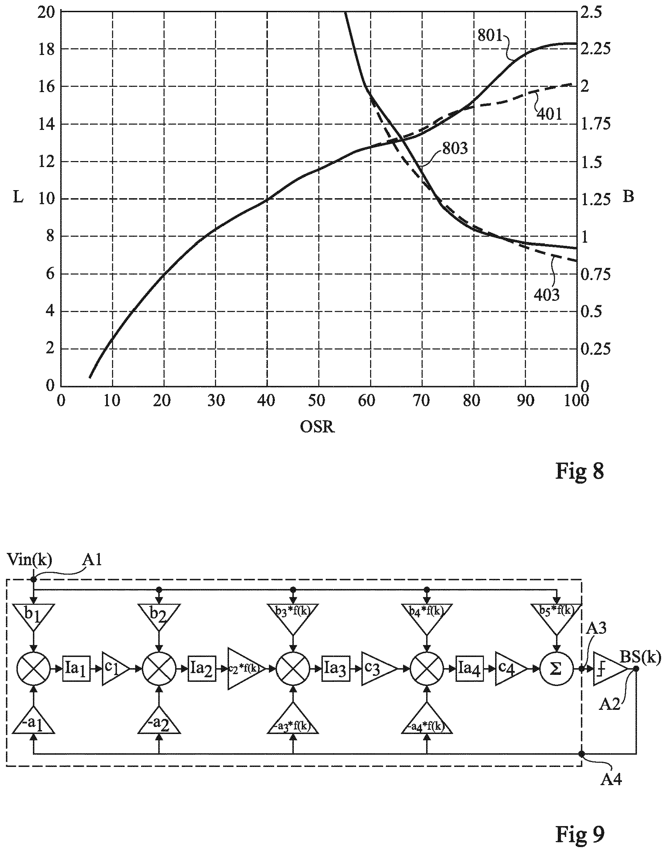

Dans l'exemple de la figure 8, la loi de pondération dynamique appliquée au convertisseur sigma-delta est définie comme suit :

pour k < 60, f(k) = 1 ;
pour 60 <= k < 75, $f(k) = e^{-(k-40)/20}$ ; et
pour k >= 75, $f(k) = e^{-(75-40)/20}$.

Sur les figures 6, 7 et 8, les courbes 601, respectivement 701, respectivement 801 représentent l'évolution de la linéarité L (en ordonnée à gauche) en fonction de l'OSR (en abscisse), et les courbes 603, respectivement 703, respectivement 803, représentent l'évolution du bruit B exprimé en LSB (en ordonnée à droite) en fonction de l'OSR. Dans cet exemple, on a considéré un convertisseur sigma-delta effectuant une quantification sur N = 16 bits. Les courbes de linéarité 401 et de bruit 403 de la figure 4, qui correspondent au même convertisseur sigma-delta mais dans lequel aucune pondération dynamique des signaux n'est effectuée, ont aussi été tracées sur les figures 6, 7 et 8 à des fins de comparaison.

Sur la figure 6, on observe que pour un OSR égal à 70, le bruit est sensiblement inchangé par rapport à l'exemple de la figure 4, mais que la linéarité est nettement améliorée, puisqu'elle passe d'une valeur environ égale à 13,5 à une valeur environ égale à 15,5. Pour des OSR plus élevés, on constate que la linéarité continue à s'améliorer par rapport à l'exemple de la figure 4, mais que le bruit augmente significativement. Cette augmentation du bruit pour les OSR élevés peut notamment s'expliquer par l'atténuation importante des échantillons d'indice k élevés par la loi f(k).

Sur la figure 7, on observe que pour un OSR égal à 140, la linéarité est augmentée d'environ 0,8 par rapport à l'exemple de la figure 4, et que le bruit reste sensiblement au même niveau que dans l'exemple de la figure 4, soit environ 0,70 LSB.

Sur la figure 8, on observe que pour un OSR égal à 100, la linéarité est augmentée d'environ 2 par rapport à l'exemple de la figure 4, et que le bruit reste sensiblement au même niveau que dans l'exemple de la figure 4.

De façon générale, on observe que les lois du type utilisé dans l'exemple de la figure 7, c'est-à-dire comportant une phase constante unitaire au début de la phase de conversion analogique-numérique du signal d'entrée, suivie d'une phase décroissante, par exemple exponentielle, à la fin de la phase de conversion, ou les lois du type utilisé dans l'exemple de la figure 8, c'est-à-dire comportant une phase constante unitaire au début de la phase de conversion analogique-numérique, suivie d'une phase décroissante, par exemple exponentielle, à un stade intermédiaire de la phase de conversion, puis d'une phase constante de niveau bas à la fin de la phase de conversion, permettent d'obtenir un bon compromis en termes de bruit et de linéarité.

Bien entendu, les plages de valeurs d'OSR d'intérêt, c'est-à-dire dans lesquelles un gain de linéarité est observé sans que le bruit ne soit dégradé de façon significative, dépendent de nombreux paramètres et notamment de l'ordre du modulateur.

On notera en outre que le gain en linéarité peut différer selon l'endroit du modulateur où est appliquée la pondération par la loi $f(k)$. En particulier, plus la pondération est appliquée en amont dans le modulateur, plus le gain en linéarité est élevé, mais plus l'augmentation du bruit de sortie sera significative si on considère un modulateur dont chaque bloc est soumis à un bruit temporel.

Pour aider au choix d'une loi de pondération $f(k)$ adaptée à l'application visée, il peut être tenu compte des considérations suivantes.

Saturation :

Les valeurs initiales (non pondérées) des coefficients du modulateur peuvent être déterminées par des méthodes usuelles de détermination des coefficients d'un modulateur sigma-delta. Généralement, pour maximiser le rapport signal sur bruit, les valeurs des coefficients sont choisies de façon à maximiser les signaux internes au modulateur, en veillant toutefois à ne pas dépasser le seuil de saturation du modulateur. L'utilisation d'une loi f présentant des valeurs de pondération $f(k)$ supérieures à 1 risque alors de conduire à la saturation du modulateur. On préférera dans ce cas une loi f dont toutes les valeurs sont inférieures ou égales à 1. Si en revanche les coefficients du modulateur sont choisis de façon que les signaux internes du modulateur restent toujours éloignés du seuil de saturation, la loi f peut présenter des valeurs supérieures à 1, ce qui permet notamment d'augmenter le rapport signal sur bruit.

Variation de la loi f :

De façon générale, la loi f peut présenter des phases de variation constante et/ou des phases de variation croissantes pour satisfaire aux diverses contraintes du convertisseur sigma-delta, notamment en termes de bruit et/ou de continuité ou de périodicité (loi cyclique) de la loi f si les intégrateurs analogiques et numériques ne sont pas réinitialisés entre deux phases successives d'acquisition d'une valeur numérique du signal (par exemple dans le cas d'un convertisseur sigma-delta utilisé pour numériser des signaux variables). Pour obtenir le gain de linéarité recherché, la loi f comporte toutefois au moins une phase de variation décroissante pendant une phase d'acquisition d'une valeur numérique du signal d'entrée.

Par ailleurs, on notera que par loi prédéterminée on entend que la loi est définie à la conception du modulateur ou lors d'une phase de configuration de ce dernier. Toutefois, la loi peut éventuellement être ajustée dynamiquement selon des règles prédéfinies, pendant une phase d'acquisition d'une valeur numérique du signal d'entrée, par exemple afin d'adapter la loi aux caractéristiques du signal en cours de conversion.

A titre de variante, plusieurs lois prédéterminées distinctes peuvent être utilisées pour pondérer les coefficients du modulateur sigma-delta. A titre d'exemple, le coefficient $c_1$ peut être multiplié par une première loi variable $f1(k)$, et le coefficient $c_2$ par une deuxième loi variable $f2(k)$ distincte de la loi f1. Dans ce cas, pour respecter les règles susmentionnées de mise à l'échelle des différents signaux du modulateur, le coefficient $c_6$ est multiplié par la loi f2, le coefficient $c_7$ est multiplié par la loi f1 et par la loi f2, et le coefficient $b_5$ est multiplié par la loi f1 et par la loi f2. Au niveau du filtre numérique, le signal d'entrée de l'intégrateur numérique de rang 2 $In_2$ peut être multiplié par la loi f1, et le signal d'entrée de l'intégrateur numérique de rang 3 $In_3$ est multiplié par la loi f2.

Dans un autre exemple, le coefficient $c_2$ peut être multiplié par une première loi variable $f1(k)$. Dans ce cas, pour respecter la mise à l'échelle des différents signaux du modulateur, les coefficients $c_6$ et $c_7$ sont multipliés par la loi $f1(k)$. Une seconde loi $f2(k)$ est appliquée au coefficient a1 de rétroaction. Le coefficient b5 est pondéré par $f1(k)*f2(k)$. Enfin, une troisième loi $f3(k)$ est appliquée au coefficient b1 du signal d'entrée Vin. Au niveau du filtre numérique, le signal d'entrée de l'intégrateur numérique de rang 1 $In_1$ peut être multiplié par la loi $f2(k+1)$ de pondération de la contre-réaction et le signal d'entrée de l'intégrateur numérique de rang 3 In$_3$ peut être multiplié par la loi f1(k+1). On notera que les règles de mise à l'échelle dans cet exemple ne sont pas appliquées en tout point, notamment entre les coefficients b1 et a1, modulés respectivement par deux lois distinctes f2 et f3. De même, la loi f3 n'est ici pas appliquée au filtre numérique. La loi de pondération du signal d'entrée du filtre diffère dans cet exemple de celle du modulateur. Certaines pondérations peuvent donc être appliquées uniquement sur l'un des coefficients du modulateur, en amont d'un intégrateur, sans remise à l'échelle en aval et sans être appliquées au filtre. Dans l'exemple précité, la loi f3 peut être différente de zéro sur les j premiers cycles, puis mise à 0 à partir d'un cycle k (avec 1 < j < k < OSR). Ainsi, le processus de quantification peut se poursuivre avec une pondération nulle du signal d'entrée, sans que cela réduise le gain en linéarité. En effet, le processus de pondération proposé permet de poursuivre la quantification du résidu de la conversion du signal d'entrée Vin, après avoir pondéré Vin de manière non nulle sur j premiers cycles.

De telles combinaisons de lois peuvent notamment permettre de relaxer les contraintes d'implémentation qui pourraient résulter de l'utilisation d'une loi de pondération unique en entrée d'un seul intégrateur analogique du modulateur et d'un seul intégrateur numérique du filtre numérique.

Les modes de réalisation décrits en relation avec les figures 5A, 5B, 6, 7 et 8 peuvent être adaptés à toutes les architectures connues de convertisseurs sigma-delta d'ordre p supérieur ou égal à 1.

La figure 9 illustre un exemple d'application à un autre type d'architecture de convertisseur sigma-delta. Sur la figure 9, seul le modulateur sigma-delta du convertisseur a été représenté. Le filtre numérique du convertisseur est par exemple identique ou similaire au filtre numérique de la figure 5B.

Le modulateur sigma-delta de la figure 9 comprend des éléments communs avec le modulateur sigma-delta de la figure 5A. Dans la suite, seules les différences entre ces deux modulateurs seront détaillées. Le modulateur de la figure 9 diffère du modulateur de la figure 5A notamment en ce que, dans le modulateur de la figure 9, les coefficients de pondération b$_2$, a$_2$, b$_3$, a$_3$, b$_4$ et a$_4$ ne sont pas nuls, et les coefficients c$_5$, c$_6$ et c$_7$ sont nuls.

Dans l'exemple de la figure 9, les coefficients de pondération c$_2$, b$_3$, a$_3$, b$_4$, a$_4$ et b$_5$ sont multipliés par une même loi variable prédéterminée f.

Comme dans l'exemple des figures 5A et 5B, on observe, dans certaines plages d'OSR, un gain significatif en termes de linéarité et un niveau de bruit sensiblement préservé par rapport au cas où tous les coefficients du modulateur seraient constants.

La figure 10 illustre, sous forme de blocs, un autre exemple de réalisation d'un convertisseur sigma-delta. Le convertisseur de la figure 10 est un convertisseur d'ordre 1, comprenant un modulateur sigma-delta d'ordre 1, et un filtre numérique d'ordre 1.

Le modulateur sigma-delta de la figure 10 comprend une borne d'entrée A1 destinée à recevoir un signal analogique d'entrée Vin à numériser, et une borne de sortie A2 destinée à fournir une suite d'échantillons binaires BS représentative du signal Vin. Le modulateur de la figure 10 comprend un circuit analogique d'intégration 101 comprenant une première entrée connectée à la borne A1 d'application du signal Vin, et une sortie A3 reliée à l'entrée d'un circuit de conversion analogique-numérique 1-bit 103, par exemple un comparateur 1-bit. La sortie du convertisseur 103 est connectée à la sortie A2 du modulateur, et est en outre reliée par une boucle de rétroaction à une deuxième entrée A4 du circuit d'intégration 101. Dans l'exemple représenté, la boucle de rétroaction comprend un convertisseur numérique-analogique 1-bit 107 (DAC) dont l'entrée est connectée à la borne A2 et dont la sortie est connectée à la borne A4. A chaque cycle k de durée T$_{OSR}$ d'une phase de conversion du signal d'entrée Vin en une valeur numérique, avec k entier allant de 0 à OSR, le circuit d'intégration 101 prélève un échantillon analogique Vin(k) du signal d'entrée, et le modulateur fournit, en sortie du convertisseur analogique-numérique 1-bit 103, un échantillon binaire BS(k) du signal de sortie. Dans l'exemple de la figure 10, le circuit d'intégration 101 comporte un unique intégrateur analogique Ia$_1$, par exemple un simple circuit de sommation analogique comportant une entrée et une sortie, ce circuit étant adapté, à chaque cycle, à incrémenter la valeur du signal de sortie (ou signal intégré) de la valeur du signal appliqué en entrée de l'intégrateur. Dans l'exemple de la figure 10, l'intégrateur Ia$_1$ reçoit sur son entrée un signal égal à la différence entre le signal d'entrée Vin(k) et le signal de rétroaction appliqué sur la borne A4 (correspondant à la valeur analogique du signal BS(k-1)), pondérée par un coefficient f(k-1) variable selon une loi f prédéterminée. L'opération de différence est symbolisée par un soustracteur 108. La sortie de l'intégrateur Ia$_1$ est connectée à la borne A3 de sortie du circuit 101.

Le filtre numérique du convertisseur sigma-delta de la figure 10 comprend un intégrateur numérique (non représenté), par exemple un compteur, dont l'entrée est reliée à la sortie A2 du modulateur par l'intermédiaire d'un circuit numérique d'application d'un coefficient de pondération f(k) variable selon la loi f. Dans cet exemple, la loi variable f est appliquée au niveau du filtre numérique avec un cycle d'avance par rapport au modulateur.

On notera que la donnée d'entrée du filtre numérique est la donnée binaire de sortie du modulateur sigma-delta, et que la résolution des données internes du filtre numérique dépend de l'OSR et de la résolution de la loi de pondération f. La résolution de la loi de pondération f dans le filtre numérique est de préférence supérieure ou égale à la résolution de la loi f dans le modulateur.

Les équations qui suivent formalisent, pour un exemple de convertisseur sigma-delta du type décrit en relation avec la figure 10, l'amélioration des performances liée à l'application d'une loi de pondération variable dans le modulateur.

On considère ici une loi f exponentielle décroissante donnée par l'équation f(k) = q$^k$, avec q$\in$]0,5;1]. On considère en outre que la dynamique du signal d'entrée Vin est limitée et satisfait à la relation |Vin| ≤ q-0,5. On considère de plus que la valeur de sortie BS(k) du modulateur sigma delta peut prendre la valeur 1 ou -1 pour k ≥ 1, et est initialisée à 0 pour k = 0. Dans cet exemple, le convertisseur numérique-analogique 107 fournit sur la borne A4 une valeur analogique égale à 0,5*BS(k-1).

Pour un OSR égal à m (avec m entier supérieur ou égal à 1), la sortie I(m) de l'intégrateur analogique peut s'écrire comme suit :

$$I(m) = \sum_{k=0}^{m-1} q^k Vin(k) - \frac{1}{2}\sum_{k=0}^{m-1} q^k BS(k) \qquad (1)$$

avec

$$BS(k) = sign\big(I(m)\big) \qquad (2)$$

On définit comme suit la séquence U(m) représentant la différence entre l'énergie accumulée provenant du signal d'entrée continu Vin et l'énergie accumulée provenant de la contre-réaction réalisée par le modulateur sigma-delta. Cette séquence U(m) représente la différence entre l'énergie introduite par le signal et son estimation.

$$U(m) = I(m) - \frac{1}{2}q^m BS(m) = \sum_{k=0}^{m-1} q^k Vin(k) - \frac{1}{2}\sum_{k=0}^{m} q^k BS(k) \qquad (3)$$

Pour montrer l'avantage du modulateur sigma-delta de la figure 10 par rapport à un modulateur sigma-delta d'ordre 1 classique, on démontre ci-après que l'assertion P(m) suivante est valable pour tout m ≥ 1 :

$$P(m): |U(m)| \leq \frac{1}{2}q^m \qquad (4)$$

On montre d'abord que pour m = 1, l'assertion P est vérifiée.

Pour 0 ≤ *Vin* ≤ *q*-0,5, on a BS(1)=1. On a alors -0,5*q* ≤ *Vin* - 0,5*q* ≤ 0,5(*q* - 1), et donc -0,5*q* ≤ U(1) ≤ 0,5*q*. Le même résultat est obtenu pour une entrée Vin négative. L'assertion P (équation (4)) est donc vérifiée pour m = 1.

On peut en outre montrer pour tout m ≥ 1, si P(m) est vérifiée, alors P(m+1) est vérifiée.

Pour *I*(*m* + 1) = *U(m)* + q$^m$*Vin* ≥ 0, on a BS(m+1) = 1. On a alors 0 ≤ *U(m)* + q$^m$*Vin* ≤ 0,5*q$^m$+q$^m$Vin,* soit -0,5 * q$^{m+1}$ ≤ *U(m)* + q$^m$*Vin* - 0,5 * q$^{m+1}$ ≤ *0,5*q$^m$+q$^m$Vin* - 0,5 * q$^{m+1}$, soit -0,5 * q$^{m+1}$ ≤ *U*(*m* + 1) ≤ q$^m$ (0,5+*Vin* - 0,5 * *q*). Etant donné que 0,5+*Vin* - 0,5 * *q* ≤ 0,5 * *q*, on a -0,5 * q$^{m+1}$ ≤ *U*(*m* + 1) ≤ 0,5 * q$^{m+1}$. De façon similaire, on peut montrer que si *I*(*m* + 1) = *U(m)* + q$^m$*Vin* ≤ 0, alors P(m+1) est vérifiée si P(m) est vérifiée.

On peut déduire de ce qui précède que l'assertion P (équation (4)) est valable pour tout m ≥ 1.

Il en résulte que

$$\left| Vin - \frac{1}{2}\frac{\sum_{k=0}^{m} q^k BS(k)}{\sum_{k=0}^{m-1} q^k} \right| \leq \frac{1}{2}\frac{q^m}{\sum_{k=0}^{m-1} q^k} \qquad (5)$$

La valeur estimée Vin$_q$ du signal Vin est alors définie par l'équation (6) ci-dessous, avec une erreur d'estimation eq définie par l'équation (7).

$$Vin_q = \frac{1}{2}\frac{\sum_{k=0}^{m} q^k BS(k)}{\sum_{k=0}^{m-1} q^k} \qquad (6)$$

$$e_q = \frac{q^m}{\sum_{k=0}^{m-1} q^k} \tag{7}$$

Pour q = 1, ce qui correspond à un convertisseur sigma-delta standard (sans modulation d'un coefficient par une loi variable), l'erreur eq vaut 1/m.

Pour m $\geq$ 1, on peut montrer que

$$\frac{q^m}{\sum_{k=0}^{m-1} q^k} \leq \frac{1}{m} \qquad (\text{équivalent à} \quad \frac{q^m(1-q)}{1-q^m} \leq \frac{1}{m} \quad) \tag{8}$$

du fait que :

$$q^m(m-mq+1) \leq 1 \tag{9}$$

En effet, le maximum du terme $q^m(m-mq+1)$ est atteint lorsque la dérivée de ce terme (par rapport à q) s'annule, c'est-à-dire pour q = 1.

Il résulte de ce qui précède que pour une valeur m d'OSR donnée, le modulateur de la figure 1 converge plus rapidement pour $q \in ]0,5;1[$ que pour q = 1 (modulateur standard, sans pondération par une loi variable).

La figure 11 est un diagramme illustrant l'évolution, en fonction de l'OSR, du nombre effectif de bits théorique ENOB défini par

$$ENOB = log_2\left((2q-1)/\left(\frac{q^m}{\sum_{k=0}^{m-1} q^k}\right)\right) \tag{10}$$

Plus particulièrement, la figure 11 comprend une courbe 901 illustrant l'évolution du nombre effectif de bits théorique ENOB pour q = 1 (cas d'un convertisseur standard), et une courbe 903 illustrant l'évolution du nombre effectif de bits théorique ENOB pour q = 1/1,1 (cas d'un convertisseur avec pondération d'un coefficient du modulateur par une loi exponentielle décroissante). On constate sur le diagramme de la figure 11 que quel que soit l'OSR considéré, le nombre effectif de bits théorique ENOB est plus élevé pour q = 1/1,1 que pour q = 1, et que la différence est d'autant plus élevée que l'OSR est élevée. A titre d'exemple, pour un OSR égal à 80, on observe une différence de près de 8 bits entre le cas q = 1/1,1 et le cas q = 1.

La figure 12 est un schéma électrique d'un exemple de réalisation d'un circuit permettant de faire varier dynamiquement un coefficient de pondération d'un modulateur sigma-delta selon une loi variable f.

Dans cet exemple, on considère que les OSR coefficients f(k) de la loi f sont quantifiés sur un nombre n de bits (n = 6 dans l'exemple représenté). On considère en outre que le coefficient de pondération que l'on souhaite moduler dynamiquement est fixé par la capacité d'un condensateur C.

Au lieu d'avoir une valeur de capacité fixe comme dans un modulateur du type décrit en relation avec la figure 2, le condensateur C est, dans cet exemple, un condensateur à capacité variable commandable numériquement, réalisé à l'aide d'une table de capacités commutées.

Plus particulièrement, dans l'exemple de la figure 12, le condensateur C est divisé en n+1 capacités $CP_1$ à $CP_{n+1}$. Les valeurs des capacités $CP_1$ à $CP_n$ sont obtenues par division dichotomique de la valeur de la capacité $C_{base}$ correspondant au coefficient de base (non pondéré). Ainsi, les capacités $CP_1$, $CP_2$, ... $CP_n$ ont respectivement les valeurs $C_{base}/2$, $C_{base}/4$, ... $C_{base}/2^n$. La capacité $CP_{n+1}$ a quant à elle la même valeur que la capacité $CP_n$. Ainsi, la somme des valeurs des capacités $CP_1$ à $CP_{n+1}$ est égale à $Cb_{ase}$.

Le condensateur à capacité variable C de la figure 12 comprend, entre des bornes de conduction E1 et E2, n+1 branches parallèles comportant chacune l'une des n+1 capacités $CP_q$, avec q entier allant de 1 à n+1, et deux interrupteurs $s_q$ commandés par un même signal de commande (ou par des signaux de commande très légèrement décalés, par exemple présentant un décalage temporel inférieur à $0,1{*}T_{OSR}$), reliant les électrodes de la capacité CPq respectivement à la borne E1 et à la borne E2.

Un circuit de commande non représenté peut être prévu pour commander les interrupteurs $s_q$ de manière à faire varier dynamiquement la capacité d'un condensateur C pendant une phase de conversion analogique-numérique du signal d'entrée du convertisseur sigma-delta.

Pour pondérer le coefficient concerné par une valeur f(k) = 1, tous les interrupteurs $s_q$ peuvent être fermés. La capacité du condensateur C est alors égale à $C_{base}$.

Pour toutes les autres valeurs (inférieures à 1 dans cet exemple) de la loi f(k), les interrupteurs $s_{n+1}$ sont ouverts, et la valeur numérique sur n bits de la loi f(k) est appliquée sur les signaux de commande des interrupteurs $s_1$ à $s_n$, le bit de poids le plus fort étant appliqué sur les interrupteurs $s_1$, et le bit de poids le plus faible étant appliqué sur les interrupteurs $s_n$.

A titre d'exemple, pour réaliser un modulateur sigma-delta du type décrit en relation avec la figure 5A, on peut partir d'un circuit du type décrit en relation avec la figure 2, dans lequel les capacités co2, Cs5, cff1 et cff2 sont remplacées par des condensateurs variables du type décrit en relation avec la figure 12.

Un avantage du circuit de la figure 12 est que la loi de pondération f(k) peut aisément être reconfigurée, par exemple si les besoins de l'application changent.

Les modes de réalisation décrits ne se limitent toutefois pas à l'exemple de circuit de la figure 12 pour faire varier dynamiquement des coefficients d'un modulateur sigma delta selon une loi prédéterminée. Plus généralement, tout autre circuit adapté peut être utilisé, par exemple un circuit à capacité variable à commande analogique ou numérique.

Des exemples de réalisation particuliers ont été décrits. Diverses variantes et modifications apparaîtront à l'homme de l'art.

En particulier, on a considéré ici uniquement des implémentations discrètes à capacités commutées, dans lesquelles le signal analogique à numériser est une tension et est échantillonné sur des capacités du modulateur sigma-delta (exemple de la figure 2). Les modes de réalisation décrits ne se limitent pas à ce cas particulier. A titre de variante, la solution proposée peut être adaptée à des modulateurs sigma-delta à entrée analogique en courant. Dans ce cas, la pondération des signaux internes au modulateur par une loi variable peut par exemple être réalisée en modulant les temps d'intégration des courants sur des capacités. Pour les modulateurs à temps continu, la loi de pondération ne sera plus discrète (f(k)) mais continue (f(t)).

Par ailleurs, on notera que la solution proposée peut être adaptée à des modulateurs sigma-delta de type MASH (de l'anglais "Multi Stage Noise Shaping" - modulateur à mise en forme du bruit multi-étage), c'est-à-dire des modulateurs d'ordre p supérieur à 1 constitués par la mise en série de plusieurs modulateurs sigma-delta d'ordre inférieur à p, chaque modulateur d'ordre inférieur à p comportant, comme dans les modulateurs décrits ci-dessus, un circuit analogique d'intégration, un convertisseur analogique-numérique 1 bit, et une boucle de rétroaction pouvant comporter un convertisseur numérique-analogique et un soustracteur. Le principe de fonctionnement des modulateurs sigma-delta de type MASH est par exemple décrit dans l'article "Sturdy MASH $\Delta$-$\Sigma$ modulator" de Maghari et al. (ELECTRONICS LETTERS 26th October 2006 Vol.42 No.22). Comme dans les exemples décrits ci-dessus, les signaux sur lesquels est appliquée la loi de pondération f(k) sont choisis de façon à ce qu'au moins une pondération par la loi f(k) soit effectuée en amont d'un intégrateur analogique du modulateur et de préférence de façon que les différents signaux additionnés ou soustraits dans le modulateur et/ou dans le filtre numérique du convertisseur soient à la même échelle.

On notera en outre que dans les exemples décrits ci-dessus, le signal analogique d'entrée est appliqué en entrée du circuit analogique d'intégration 101 du modulateur, et le convertisseur analogique-numérique 1-bit 103 du modulateur compare un signal de sortie du circuit 101 à un signal de référence constant. A titre de variante, le signal d'entrée et le signal de référence peuvent être intervertis. Dans ce cas, les inventeurs ont constaté que si les coefficients du modulateur sont fixes, le bruit de sortie du convertisseur sigma-delta est relativement élevé. En revanche, l'application d'une loi de pondération variable sur des coefficients du modulateur permet d'améliorer de façon significative la précision du convertisseur. Un avantage de cette variante de réalisation est que l'entrée de référence du comparateur 103 est une entrée haute impédance. Ainsi, l'application du signal à convertir directement sur le comparateur permet d'éviter de tirer de la puissance sur le signal à numériser.

Par ailleurs, on a décrit ci-dessus des exemples de réalisation de modulateurs sigma-delta comportant un ou plusieurs intégrateurs analogiques cascadés. Les modes de réalisation décrits ne se limitent pas à ce cas particulier. Plus généralement, dans les modes de réalisation décrits, les intégrateurs analogiques des modulateurs sigma-delta peuvent être remplacés par d'autres types de filtres analogiques.

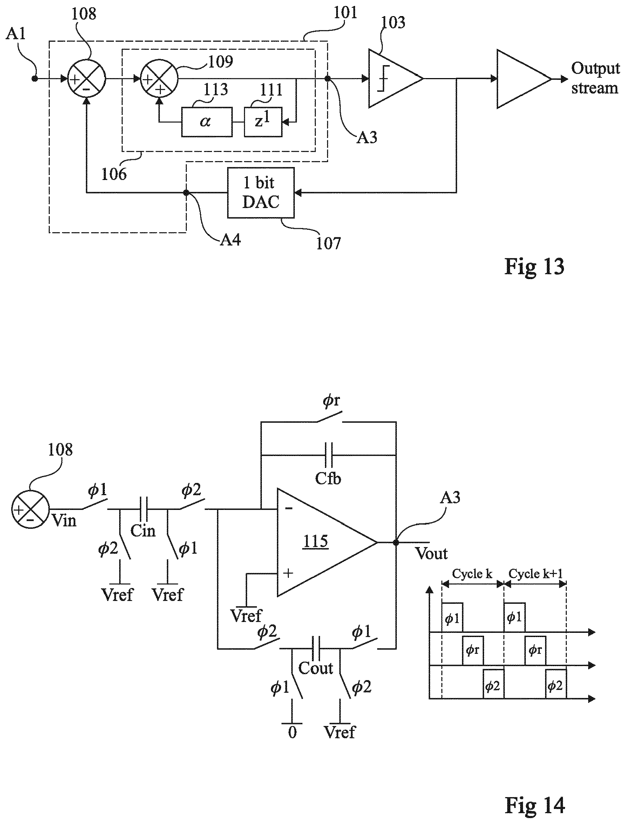

La figure 13 illustre, sous forme de blocs, un autre exemple de réalisation d'un convertisseur sigma-delta d'ordre 1. Sur la figure 13, seul le modulateur sigma-delta du convertisseur a été représenté. On retrouve comme sur la figure 10, le circuit analogique d'intégration 101, le circuit de conversion analogique-numérique 1-bit 103 et le convertisseur numérique-analogique 1-bit 107 et le soustracteur 108. A la différence de la figure 10, le filtre analogique 106 du circuit analogique d'intégration 101 représenté sur la figure 13 comprend un sommateur 109, un opérateur de retard 111 à gain unitaire, noté $Z^{-1}$ et un multiplicateur 113 permettant de multiplier le signal de sortie de l'opérateur 111 par un facteur $\alpha$. Le sommateur 109 additionne le signal analogique reçu au cycle k et un signal interne au filtre analogique issu de l'opérateur 111 multiplié par le coefficient $\alpha$. La sortie du sommateur 109 alimente l'entrée de l'opérateur 111 et forme la sortie A3 du circuit d'intégration 101. Ainsi le signal interne au filtre analogique issu de l'opérateur 111 forme la sortie du filtre analogique au cycle k-1. En choisissant une valeur du coefficient $\alpha$ supérieure strictement à 1, la contribution à la valeur de sortie du filtre analogique au point A3 du signal analogique d'entrée du sommateur 109 issu du soustracteur 108 au cycle k est plus faible que sa contribution au filtre analogique au cycle précédent k-1. Il suffit qu'au cours d'au moins un cycle durant la phase de conversion, le coefficient $\alpha$ soit supérieur strictement à 1 pour que la condition de contribution soit respectée. Il est bien entendu possible de prévoir un coefficient $\alpha$ supérieur strictement à 1 pour plusieurs cycles voire pour tous les cycles d'une phase de conversion.

Les blocs fonctionnels représentés sur la figure 13 peuvent être réalisés de nombreuses façons dont une est explicitée sur la figure 14. Il est bien entendu possible de réaliser le sommateur, 109, l'opérateur 111 et le multiplicateur 113 sous d'autres formes en fonction de composants existants sur le marché et de leur facilité de mise en oeuvre.

Sur la figure 14, le sommateur, 109, l'opérateur 111 et le multiplicateur 113 sont réalisés à partir d'un amplificateur opérationnel 115 recevant sur son entrée inverseuse le signal interne issu du soustracteur 108 par l'intermédiaire d'une capacité Cin. Des interrupteurs $\Phi 1$ et $\Phi 2$ permettent de connecter la capacité Cin soit à la sortie du sommateur 108, soit à une tension de référence Vref soit à l'entrée inverseuse. L'entrée inverseuse est raccordée à la sortie de l'amplificateur opérationnel 115 par l'intermédiaire d'une capacité Cfb qui peut être court-circuitée par un interrupteur $\Phi r$. L'entrée inverseuse est également raccordée à la sortie de l'amplificateur opérationnel 115 par l'intermédiaire d'une capacité Cout qui peut être commutée par des interrupteurs également appelés $\Phi 1$ et $\Phi 2$. Bien que les interrupteurs commutant les capacités Cin et Cout soient différents, des mêmes appellations sont utilisées pour les interrupteurs commutés simultanément. Un chronogramme est représenté sur la figure 14 pour montrer l'enchainement par cycle de trois phases de commutation des interrupteurs $\Phi 1$, $\Phi 2$ et $\Phi r$. Pour simplifier la compréhension, les trois phases $\Phi 1$, $\Phi 2$ et $\Phi r$ sont appelées par l'appellation des interrupteurs fermés lors de chacune des phases.

Lors de la phase $\Phi 1$, on a les quantités de charges suivantes sur les capacités Cin et Cout :

$$Qcin = Cin*(Vref-Vin(k))$$

$$Qcout = Cout*(0-Vout(k-1))$$

Lors de la phase $\Phi r$, l'intégrateur constitué de l'amplificateur 115 avec la capacité Cfb est réinitialisé en court-circuitant Cfb. Sa charge Qcfb devient nulle.

Lors de la phase $\Phi 2$, la totalité des charges Qcin et Qcout sont transférées sur la capacité Cfb. On a alors :

$$Qcin + Qcout = Cfb*(Vref-Vout(k))$$

En résolvant cette expression avec Cin = Cfb = C, et en posant Cout = $\alpha*$C, on obtient :

$$Vout(k) = Vin(k) + \alpha*Vout(k-1)$$

Le rapport entre les valeurs des capacités Cout d'une part et Cfb et Cin d'autre part donne la valeur du coefficient $\alpha$.

A partir de l'exemple de la figure 10, on a montré plus haut l'intérêt de l'invention à partir de l'exemple d'une loi exponentielle décroissante fonction du rang k du cycle : $f(k) = q^k$. Pour obtenir le même résultat dans la variante décrite à partir de la figure 13, on peut donner au coefficient $\alpha$ une valeur égale à 1/q.

La pondération $\alpha$ de l'intégrateur est constante ; 1/q, mais la contribution du signal d'entrée de l'intégrateur dans l'intégrateur décroit en suivant la loi $f(k) = q^k$. Par ailleurs, la pondération de la sortie du filtre numérique peut suivre la loi $f(k)$ (ou $f(k+1)$) compte tenu du décalage d'application théorique entre le modulateur et le filtre numérique. Une autre loi décroissante peut aussi être choisie pour le filtre numérique.

La variante de réalisation décrite à partir des figures 13 et 14 présente l'avantage de ne pas introduire nécessairement de facteur d'échelle à la sortie du circuit d'intégration 101. On a néanmoins un risque de saturation de l'intégrateur du fait d'un gain supérieur à 1.

Dans la variante décrite à l'aide de la figure 10, à chaque cycle, la pondération de chaque signal d'entrée de l'intégrateur $Ia_1$ est donnée par $q^k$, de sorte que la contribution du signal d'entrée sur la valeur de l'intégrateur suive la relation :

$$\frac{q^k}{\sum_{i=1}^{k-1} q^i}$$

Dans la variante décrite à l'aide de la figure 13, à chaque cycle, la contribution du signal d'entrée sur la valeur de l'intégrateur 106 suit la relation :

$$\frac{1}{\sum_{i=1}^{k-1} \dfrac{1}{q^i}}$$

Ces deux relations sont complètement équivalentes.

Une autre façon d'exprimer l'équivalence des deux pondérations est de définir dans la variante illustrée par la figure 10, la pondération en entrée de l'intégrateur par $\beta_k$ (k variant de 1 à OSR) et par $\alpha_k$ le gain de l'intégrateur au rang k dans la variante illustrée par la figure 13.

On a alors :

$$\beta_k = \prod_{i=1}^{k} \frac{1}{\alpha_i}$$

Il est nécessaire de remplir la condition $\beta_k < \beta_{k-1}$ (ou au moins un $\alpha_k > 1$ dans un intégrateur) pour au moins un rang k donné afin que la contribution d'un signal en entrée de l'intégrateur présente une phase de décroissance au cours d'une conversion de OSR cycles.

Un avantage d'une décroissance exponentielle à l'entrée de l'intégrateur (figure 10) est lié à la consommation. En effet, dans une réalisation à capacités commutées, la consommation liée à la charge de capacités de valeur décroissante permet de réduire la consommation dynamique. Néanmoins, cette atténuation du gain peut entrainer une hausse du bruit temporel. Cependant, dans certaines applications d'imagerie par exemple, la linéarité de la valeur numérique produite en sortie du convertisseur est plus importante que le bruit temporel sur cette valeur numérique. En effet, sur une série d'image, l'oeil aura tendance à lisser ou à moyenner le bruit temporel et sera de ce fait plus sensible aux erreurs de linéarités (si on considère ici une population de valeurs numériques de sortie relatives à plusieurs conversions d'une même valeur statique analogique d'entrée, le bruit est relatif à l'écart type de la population et l'erreur de linéarité à la différence entre la valeur numérique théorique attendue et la moyenne de la population). Ainsi, comme il l'a été démontré plus haut, l'invention proposée et notamment sa variante expliquée à partir de la figure 10, réduit malgré tout l'erreur de linéarité.

Avec la variante proposée à partir de la figure 13 dans laquelle on multiplie par 1/q le gain de l'intégrateur, on gagne en linéarité tout en affectant de manière réduite le bruit car l'amplitude (ou plus précisément l'enveloppe) des signaux n'est pas atténuée en entrée et en sortie des intégrateurs.

La variante expliquée à l'aide de la figure 10 et la variante expliquée à l'aide de la figure 13 peuvent être combinées afin d'éviter le risque de saturation au niveau de l'intégrateur. Cette combinaison consiste par exemple à appliquer une loi de pondération sur le signal d'entrée de l'intégrateur Ia1 par exemple de type $f(k) = q^k$ avec k variant de 1 à OSR, selon la variante de la figure 10, et au moins une fois et avantageusement périodiquement tous les N cycles à l'intérieur des OSR cycles, à réinitialiser la loi de pondération et tout en appliquant à l'intégrateur un gain correspondant selon la variante de la figure 13. La loi de pondération suit alors la loi q à la puissance (k-n*partie entière de (k/n)) et tous les N cycles on applique un gain $(1/q)^N$ à l'intégrateur.

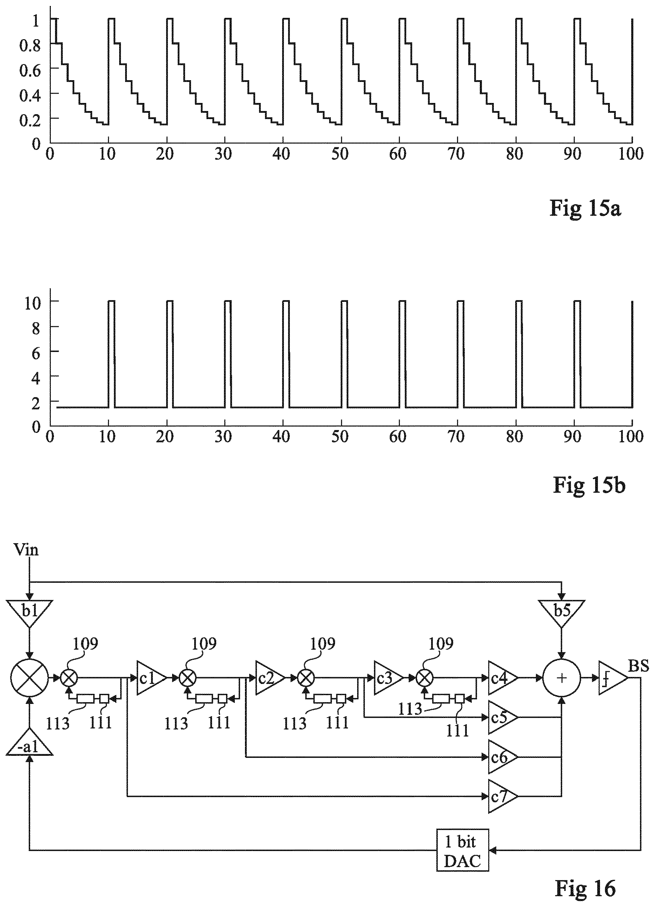

La figure 15a représente sous forme de chronogramme dont l'axe des temps est exprimé en nombre de cycles l'évolution de la pondération en entrée de l'intégrateur selon la variante de la figure 10. Dans cet exemple la loi f est de la forme $f(k) = q^k$ avec q = 0,8. Le nombre de cycles total OSR pour produire une valeur numérique de sortie est de 100 et le nombre N de cycles au bout duquel on réinitialise la pondération en entrée de l'intégrateur est de 10. Au premier cycle de la phase de conversion, la pondération est de 0.8 et suit la relation $0,8^k$ jusqu'au dixième cycle puis est réinitialisée à 1 au onzième cycle. Cette décroissance suivie d'une réinitialisation est répétée tous les 10 cycles jusqu'à OSR = 100.

La figure 15b représente sous forme de chronogramme avec le même axe des temps, la pondération appliquée au gain de l'intégrateur selon la variante de la figure 13. Tous les N cycles, 10 dans l'exemple représenté, le gain $\alpha$ de

l'intégrateur (initialement égal à 1) est multiplié par $(1/q)^N$ c'est-à-dire $(1/0,8)^{10} \approx 9,31$, puis est réinitialisé à sa valeur initiale au cycle suivant.

Ainsi, on conserve la propriété d'une contribution de la valeur d'entrée de l'intégrateur qui suit la loi f(k). Dans cette combinaison, le risque de saturation est réduit et la robustesse au bruit est accrue du fait de la moindre atténuation intervenant sur le signal d'entrée de l'intégrateur.

Une autre combinaison des deux variantes des figures 10 et 13 consiste à réaliser simultanément, au moins pour un même rang k, à la fois une pondération en entrée d'intégrateur et un gain dans l'intégrateur.

On a vu plus haut à l'aide de la figure 5a que la variante de la figure 10 peut être généralisée à des convertisseurs d'ordre supérieur à 1 comprenant plusieurs filtres analogiques cascadés. Il en est de même pour la variante présentée à l'aide de la figure 13 qui peut être généralisée à des convertisseurs d'ordre supérieur à 1. Cette généralisation est présentée sur la figure 16 où chaque intégrateur Ia1 à Ia4 de la figure 1a est remplacé par un sommateur 109, un opérateur 111 et un multiplicateur 113. Il est bien entendu possible de ne remplacer qu'au moins un des intégrateurs Ia1 à Ia4 de la figure 1a par un sommateur 109, un opérateur 111 et un multiplicateur 113.

Dans le cas où plusieurs multiplicateurs 113 sont présents, le facteur $\alpha$ de chacun peut être différent afin d'ajuster les plages de variation de sortie des filtres analogiques intégrateurs. Le filtre numérique est alors avantageusement adapté en fonction des différents facteurs $\alpha$.

Plus haut, il a été précisé que diverses variantes d'architectures de filtres numériques peuvent être envisagées. En particulier, la topologie du filtre numérique peut être modifiée pour se rapprocher de celle du modulateur sigma-delta. Dans le cas d'un modulateur à filtres analogiques cascadés, il est avantageux de réaliser le filtre numérique au moyen de filtres élémentaires de mêmes types et cascadés de la même façon. Par filtre du même type, on entend par exemple des filtres passe haut, passe bas, passe bande, intégrateur... qui seront analogiques dans le modulateur et numériques dans le filtre numérique.

Dans le cas particulier d'intégrateurs numériques cascadés, différents filtres élémentaires peuvent être mis en oeuvre de façon équivalente. Il est par exemple possible de prévoir deux variantes de filtre élémentaire. Dans la première variante, un intégrateur à gain unitaire est précédé d'un multiplicateur, à l'image du modulateur de la figure 10. Dans la seconde variante, le filtre élémentaire comprend un intégrateur à gain non unitaire à l'image du modulateur de la figure 13. Des cascades d'intégrateurs selon les deux variantes sont néanmoins complètement équivalentes et peuvent toutes deux être mises en oeuvre en sortie d'un modulateur selon la figure 10 ou en sortie d'un modulateur selon la figure 13.

Pour prouver cette équivalence, le tableau suivant présente une cascade de deux intégrateurs à gain unitaire précédée d'un multiplicateur de coefficient $q^k$. Dans ce tableau on considère que l'entrée du filtre est unitaire :

| Rang k | Entrée de l'intégrateur 1 | Sortie de l'intégrateur 1 | Sortie de l'intégrateur 2 |
|--------|---------------------------|---------------------------|---------------------------|
| 1 | $q$ | 0 | 0 |
| 2 | $q^2$ | $q$ | 0 |
| 3 | $q^3$ | $q^2+q$ | $q$ |
| 4 | $q^4$ | $q^3+q^2+q$ | $q^2+2q$ |
| 5 | $q^5$ | $q^4+q^3+q^2+q$ | $q^3+2q^2+3q$ |

La valeur de sortie du second intégrateur est égale à :

$$\sum_{i=1}^{k-2}((k-2)-i+1)q^i$$

Le rapport entre la sortie du second intégrateur et l'entrée du premier intégrateur pour deux rangs k d'écart est égal à :

$$\frac{\sum_{i=1}^{k-2}((k-2)-i+1)q^i}{q^{k-2}}$$

Le tableau suivant présente une cascade de deux intégrateurs à gain 1/q :

| Rang k | Entrée de l'intégrateur 1 | Sortie de l'intégrateur 1 | Sortie de l'intégrateur 2 |
|--------|---------------------------|---------------------------|---------------------------|
| 1 | 1 | 0 | 0 |
| 2 | 1 | 1 | 0 |
| 3 | 1 | $1+q^{-1}$ | 1 |
| 4 | 1 | $1+q^{-1}+q^{-2}$ | $1+2q^{-1}$ |
| 5 | 1 | $1+q^{-1}+q^{-2}+q^{-3}$ | $1+2q^{-1}+3q^{-2}$ |

La sortie de l'intégrateur 2 et le rapport entre la sortie du second intégrateur et l'entrée du premier intégrateur pour deux rangs k d'écart sont égaux à

$$\frac{\sum_{i=1}^{k-2}((k-2)-i+1)q^{i}}{q^{k-2}}$$

Les deux rapports sont bien identiques ce qui montre l'équivalence des deux variantes de filtre numérique. Cette équivalence a été montrée pour une cascade de deux filtres. Il est bien entendu que l'équivalence entre les deux variantes est obtenue quel que soit le nombre de filtres élémentaires cascadés.

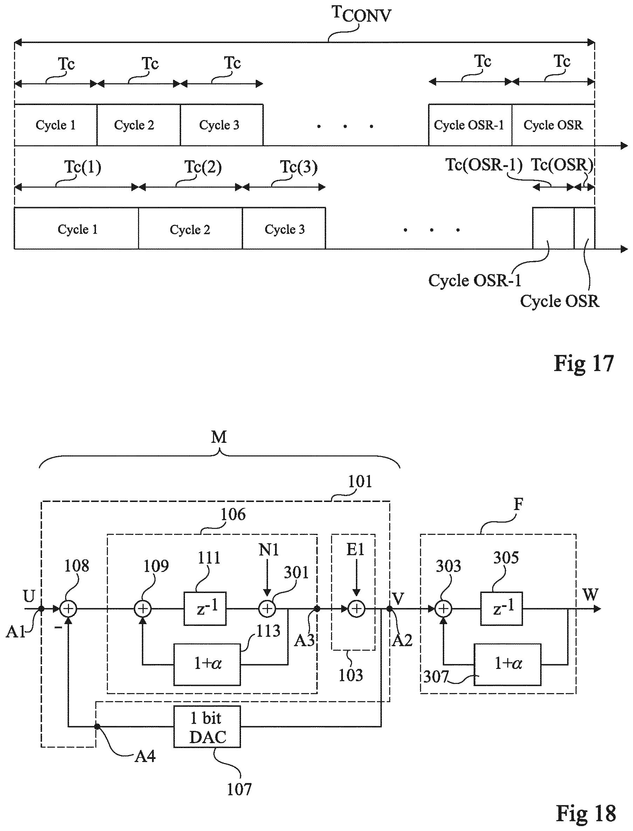

La figure 17 illustre schématiquement le fonctionnement d'un convertisseur sigma-delta selon un exemple d'un mode de réalisation.

Dans les exemples de réalisation de convertisseurs sigma-delta décrits précédemment, en particulier en relation avec les figures 10 et 13, la contribution à au moins un filtre analogique d'un signal analogique interne issu du signal analogique d'entrée Vin(k) est plus faible à un cycle k donné d'une phase de conversion qu'à un cycle précédent k-1 de la phase de conversion. Toutefois, dans tous les exemples décrits précédemment, les OSR cycles de fonctionnement de la phase de conversion ont sensiblement la même durée $T_c=T_{OSR}$, par exemple égale à $T_{CONV}/OSR$, où $T_{CONV}$ désigne la durée totale de la phase de conversion. Ce fonctionnement est illustré par le chronogramme représenté en partie haute de la figure 17, illustrant la répartition temporelle des OSR cycles de fonctionnement successifs d'une phase de conversion analogique numérique de durée $T_{CONV}$.

Selon un aspect d'un mode de réalisation, on prévoit, dans un convertisseur sigma-delta du type décrit précédemment, dans lequel la contribution à au moins un filtre analogique d'un signal analogique interne issu du signal analogique d'entrée Vin(k) est plus faible à un cycle k donné d'une phase de conversion qu'à un cycle précédent k-1 de la phase de conversion, de faire varier la durée des cycles de fonctionnement selon une loi $T_c$ prédéterminée fonction du rang k du cycle dans la phase de conversion, de façon que la durée $T_c(k)$ d'au moins un cycle k donné de la phase de conversion soit inférieure à la durée $T_c(k-1)$ d'un cycle précédent k-1 de la phase de conversion. Ce mode de fonctionnement est illustré par le chronogramme représenté en partie basse de la figure 17, illustrant la répartition temporelle des OSR cycles de fonctionnement successifs d'une phase de conversion analogique numérique de durée $T_{CONV}$.

Un intérêt de ce mode de fonctionnement va maintenant être expliqué en relation avec la figure 18.

La figure 18 illustre, sous forme de blocs, un exemple de réalisation d'un convertisseur sigma-delta d'ordre 1. Sur la figure 18, le modulateur sigma-delta M et le filtre numérique F du convertisseur ont été représentés.

Pour le modulateur M, on retrouve, comme sur la figure 13, un soustracteur 108, un filtre analogique 106, un circuit de conversion analogique numérique 1-bit 103, et une boucle de rétroaction comportant un convertisseur numérique analogique 1-bit 107. L'entrée positive du soustracteur 108 est reliée à une borne A1 d'application d'un signal d'entrée du convertisseur, la sortie du soustracteur 108 est reliée à l'entrée du filtre analogique 106, la sortie A3 du filtre analogique 106 est reliée à l'entrée du convertisseur analogique numérique 1-bit 103, et la sortie A2 du convertisseur analogique numérique 1-bit 103 est reliée à l'entrée négative A4 du soustracteur 108 par l'intermédiaire du convertisseur numérique analogique 1-bit 107. Dans l'exemple de la figure 18, le convertisseur analogique numérique 1 bit est représenté sous la forme d'un sommateur ajoutant au signal de sortie du filtre analogique 106 un bruit de quantification E1 introduit par le convertisseur 103. Le filtre analogique 106 comprend un sommateur 109, un opérateur de retard 111 à gain unitaire noté $Z^{-1}$, et un multiplicateur 113 permettant de multiplier le signal de l'opérateur 111 par un facteur $1+\alpha$, où $\alpha$ est un coefficient positif. Une première entrée du sommateur 109 est reliée à l'entrée du filtre 106, c'est-à-dire à la sortie du soustracteur 108. La sortie du sommateur 109 est reliée à l'entrée de l'opérateur 111, la sortie de l'opérateur 111 étant reliée à la sortie du filtre analogique 106. Le multiplicateur 113 relie la sortie du filtre analogique 106 à une deuxième entrée du sommateur 109. Dans l'exemple de la figure 18, un bruit temporel N1 associé à l'intégrateur analogique 106 a en outre été représenté. Plus particulièrement, dans cet exemple, le bruit N1 est ajouté au signal de sortie de l'opérateur 111 par l'intermédiaire d'un sommateur 301 placé entre la sortie de l'opérateur 111 et la sortie du filtre analogique 106. A chaque cycle k de fonctionnement du convertisseur sigma-delta, le sommateur 109 additionne le signal reçu au cycle k à l'entrée du filtre analogique 106 et un signal interne au filtre 106 correspondant à la somme du signal issu de l'opérateur 111 et du signal N1, multipliée par le facteur 1+α.

Le filtre numérique F comprend un sommateur 303, un opérateur à retard 305 à gain unitaire, noté $Z^{-1}$, et un multiplicateur 307 permettant de multiplier le signal de l'opérateur 305 par le facteur 1+α. Une première entrée du sommateur 303, correspondant à l'entrée du filtre F, est reliée à la borne de sortie A2 du modulateur M. La sortie du sommateur 303 est reliée à l'entrée de l'opérateur 305, la sortie de l'opérateur 305 étant reliée à la sortie du filtre numérique F. Le multiplicateur 307 relie la sortie de l'opérateur 305 à une deuxième entrée du sommateur 303. A chaque cycle k de fonctionnement du convertisseur sigma-delta, le sommateur 303 additionne le signal reçu au cycle k à l'entrée du filtre numérique F et un signal interne au filtre F correspondant au signal issu de l'opérateur 305 multiplié par le facteur 1+α.

On désigne ici par U le signal d'entrée du modulateur M appliqué sur la borne A1, par V le signal de sortie du modulateur M fourni sur la borne A2, et par W le signal de sortie du filtre numérique F fourni en sortie de l'opérateur 305.

A partir du schéma de la figure 18, on peut écrire la relation suivante :

$$V = z^{-1}U + (1 - (1 + \alpha)z^{-1})E1 + N1 = STF.U + NTF.E1 + N1$$

où STF et NTF désignent respectivement la fonction de transfert de signal et la fonction de transfert de bruit du modulateur sigma-delta. On voit que dans ce cas, le bruit de quantification E1 est mis en forme par la NTF, qui constitue un filtre passe-haut. En revanche, le signal d'entrée U ainsi que le bruit temporel N1 associé à l'intégrateur analogique sont transférés en sortie du modulateur sans atténuation.

A la sortie du filtre numérique F, on obtient la relation suivante :

$$W = \frac{z^{-2}}{1 - (1 + \alpha)z^{-1}} U + z^{-1}E1 + \frac{z^{-1}}{1 - (1 + \alpha)z^{-1}} N1$$

L'équivalent de cette dernière relation dans le domaine temporel discrétisé est donné par la relation suivante :

$$W(n) = \sum_{k=1}^{n-2} (1 + \alpha)^{k-1} U_{n-k-1} + \sum_{k=1}^{n-2} (1 + \alpha)^{k-1} N1_{n-k} + E1_{n-1}$$

Après normalisation, on peut exprimer la contribution rms (de l'anglais "root mean square" - moyenne quadratique) S du bruit N1 dans le signal W(k) par la relation :

$$S = \frac{\sqrt{\sum_{k=1}^{n-2}(1 + \alpha)^{2(k-1)} N1_{n-k}^2}}{\sum_{k=1}^{n-2}(1 + \alpha)^{k-1}}$$

Dans le cas d'un bruit N1 de puissance constante $\sigma^2$ d'un cycle à l'autre, la contribution S devient :

$$S = \frac{\sqrt{\sum_{k=1}^{n-2}(1 + \alpha)^{2(k-1)} \sigma^2}}{\sum_{k=1}^{n-2}(1 + \alpha)^{k-1}}$$

Lorsque α = 0, on retrouve la relation classique traduisant l'étalement du bruit sur une bande OSR fois plus large que la bande d'origine (lié au sur-échantillonnage d'un facteur OSR = n-2) :

$$S = \sqrt{\frac{\sigma^2}{n-2}}$$

Les équations ci-dessus mettent en avant l'intérêt du facteur $\alpha$ strictement supérieur à 0, qui va permettre une atténuation de la contribution du bruit de quantification E1 dans le code normalisé de sortie. En revanche, la contrepartie est l'amplification du bruit N1, ou, plus généralement, de toute source de bruit non mise en forme par la NTF à la manière du bruit de quantification E1.

L'expression ci-dessus de la valeur S en fonction de N1 montre en outre que, lorsque le coefficient $\alpha$ est non nul, la contribution des échantillons $N1_k$ du bruit N1 n'est pas constante mais décroit en fonction du rang k du cycle dans la phase de conversion. En d'autres termes, le bruit N1 associé au premier cycle contribue davantage que le bruit N1 associé au cycle suivant, et ainsi de suite.

Le mode de fonctionnement exposé en relation avec la figure 17, consistant à faire varier les durées des cycles de fonctionnement de la phase de conversion en fonction du rang k des cycles, en attribuant des durées plus longues sur les cycles initiaux puis en réduisant la durée des cycles suivants permet, sans augmenter la durée totale de conversion $T_{CONV}$, de diminuer la contribution du bruit N1 non mis en forme par la NTF dans la valeur numérique de sortie du convertisseur. En effet, augmenter la durée des temps de cycles initiaux permet de réduire la bande passante du filtre analogique pour le bruit temporel N1 lors de ces cycles, et donc de réduire la puissance du bruit N1 dans les cycles initiaux. A contrario, réduire la durée des temps de cycles suivants conduit à augmenter la bande passante du filtre analogique avec pour effet d'augmenter la puissance du bruit N1 lors de ces cycles. Toutefois, comme expliqué ci-dessus, lorsque le coefficient $\alpha$ est non nul, la contribution d'un échantillon $N1_k$ du bruit N1 dans le signal final est d'autant plus faible que le rang k du cycle de la phase de conversion est élevé. Ainsi, prévoir des durées de cycles décroissantes permet de réduire la contribution totale du bruit N1 dans la valeur de sortie finale du convertisseur.

Au moins une diminution de la durée de cycle entre deux cycles de rangs successifs de la phase de conversion apporte déjà un avantage. De préférence, la loi $T_c(k)$ régissant la durée des cycles de fonctionnement du convertisseur en fonction du rang k des cycles est une loi décroissante sur toute la durée de la phase de conversion $T_{CONV}$, c'est-à-dire qu'elle ne comporte pas de phase d'augmentation de la durée de cycle entre deux cycles successifs de la phase de conversion. La loi $T_c(k)$ est par exemple une loi décroissante continue sur toute la durée de la phase de conversion $T_{CONV}$, comme illustré en figure 17. A titre de variante, la loi $T_c(k)$ est une loi décroissante par paliers, par exemple par paliers de plusieurs cycles consécutifs, ce qui présente l'avantage de simplifier la mise en oeuvre de la variation de durée des cycles dans le convertisseur.

A titre d'exemple illustratif, on considère une phase de conversion analogique-numérique de durée $T_{CONV}$ comportant OSR = 400 cycles de fonctionnement, dans laquelle les 15 premiers cycles ont une durée t1, les 20 suivants une durée t2 et les 365 restants une durée t3, avec 15*t1 + 20*t2 + 365*t3 = $T_{CONV}$, et avec t1 = 15*$T_{CONV}$/400 et t2 = 5*$T_{CONV}$/400. Par rapport à un mode de fonctionnement dans lequel tous les cycles durant lesquels on effectue une opération de transfert de charges entre une capacité d'entrée et une capacité d'intégration (tel que dans l'intégrateur Ia1 dans la Figure 2 où les charges de la capacité Cs1 sont transférées à chaque cycle dans la capacité Ci1), ont la même durée t = $T_{CONV}$/400, la puissance du bruit N1 correspondant au bruit de sortie de l'intégrateur peut être divisée par 15 dans les 15 premiers cycles en exploitant ce temps supplémentaire pour réduire la bande passante du montage d'intégration, par 5 dans les 20 cycles suivants, et être multipliée par 5 dans les 365 cycles restants (t3 = 75*t/365 = 0,2t). Lorsque le coefficient $\alpha$ est non nul, l'usage de cycles de durée plus importante en début de conversion permet de réduire le bruit et de tendre, à temps de conversion équivalent, vers le bruit d'une structure standard ($\alpha$ = 0) dans laquelle la durée des temps de cycles est constante.

Plus généralement, le mode de fonctionnement de la figure 17, consistant à faire décroitre la durée des cycles de fonctionnement au cours de la phase de conversion, est avantageux dans tout convertisseur sigma-delta dans lequel la contribution à au moins un filtre analogique d'un signal analogique interne issu du signal analogique d'entrée Vin(k) est plus faible à un cycle k donné d'une phase de conversion qu'à un cycle précédent k-1 de la phase de conversion, par exemple un convertisseur du type décrit en relation avec la figure 10, dans lequel un signal interne au filtre analogique est pondéré par un coefficient variable.

Pour implémenter un convertisseur sigma-delta à temps de cycle variable, on pourra par exemple prévoir de faire varier la valeur d'une ou plusieurs capacités du filtre analogique du modulateur proportionnellement à la durée du cycle de fonctionnement. A titre de variante, la bande passante du filtre analogique peut être ajustée dynamiquement pendant la phase de conversion en jouant sur le courant de polarisation de l'amplificateur utilisé pour implémenter le filtre analogique.

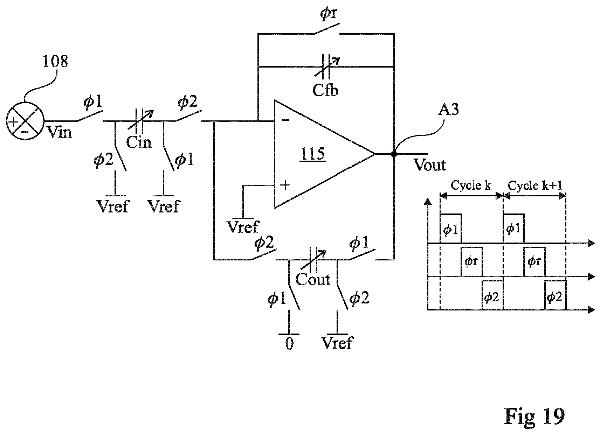

La figure 19 illustre un exemple de réalisation d'un filtre analogique pouvant être mis en oeuvre dans un convertisseur sigma-delta du type décrit à partir de la figure 17.

Le filtre analogique de la figure 19 est sensiblement identique au filtre analogique de la figure 14, à la différence près que, dans l'exemple de la figure 19, les capacités Cin, Cout et Cfb sont des capacités variables. Un chronogramme est représenté sur la figure 19 pour montrer l'enchainement par cycle de trois phases de commutation des interrupteurs Φ1, Φ2 et Φr. Le fonctionnement est sensiblement identique à celui de la figure 14, à savoir que chaque cycle k de fonctionnement du modulateur comprend une phase Φ1 de fermeture des interrupteurs Φ1, suivie d'une phase Φr de fermeture des interrupteurs Φr, suivie d'une phase Φ2 de fermeture des interrupteurs Φ2. Toutefois, à la différence de l'exemple de la figure 14, dans l'exemple de la figure 19, la durée des cycles de fonctionnement du convertisseur varie pendant une phase de conversion analogique numérique. A chaque variation de la durée de cycle du convertisseur, les valeurs des capacités Cin, Cfb et Cout sont ajustées en conséquence. En considérant l'exemple numérique illustratif susmentionné ($T_{CONV}$ = 15*t1 + 20*t2 + 365*t3), on pourra par exemple prévoir, par rapport à un convertisseur à durée de cycle constante ($T_{CONV}$ = 400*t), de multiplier les capacités Cin, Cfb et Cout de l'intégrateur analogique par 15 pendant les 15 premiers cycles de fonctionnement, par 5 pendant les 20 cycles suivants, et de les diviser par 5 pendant les 365 cycles suivants.

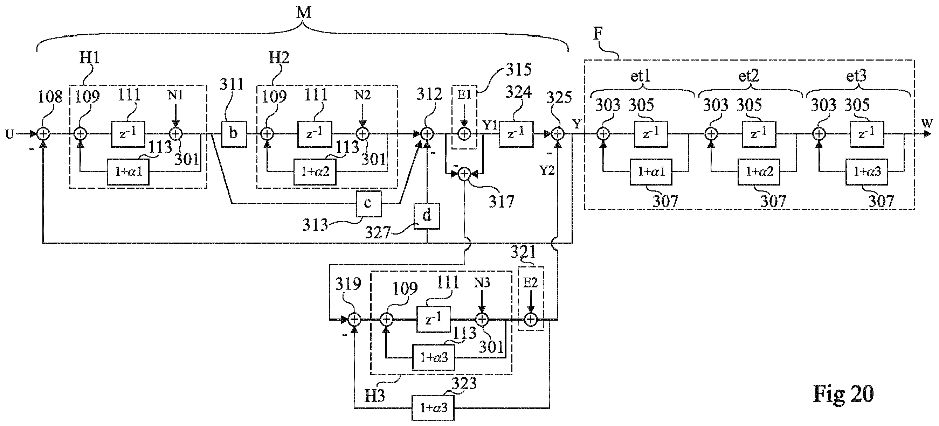

La figure 20 illustre sous forme de blocs une généralisation de l'exemple de la figure 19 à des convertisseurs d'ordre supérieur à 1.

Le convertisseur de la figure 20 correspond à un exemple d'implémentation particulier d'un convertisseur sigma-delta d'ordre 3 de type SMASH, réalisé à partir de deux sous-modulateurs sigma-delta d'ordre 2 et 1 respectivement. Le modulateur sigma-delta M du convertisseur de la figure 1 comprend trois intégrateurs analogiques H1, H2, H3 présentant chacun une structure identique ou similaire à celle de l'intégrateur analogique 106 de la figure 18. On désigne ici par N1, respectivement N2, respectivement N3, le bruit temporel associé à l'intégrateur H1, respectivement H2, respectivement H3. Par ailleurs, les multiplicateurs 113 des intégrateurs H1, respectivement H2, respectivement H3, appliquent des coefficients de multiplication 1+α1, respectivement 1+α2, respectivement 1+α3. Le modulateur M comprend, comme dans l'exemple de la figure 18, un soustracteur 108 dont l'entrée positive est reliée à une borne d'application d'un signal d'entrée du convertisseur. La sortie du soustracteur 108 est reliée à l'entrée de l'intégrateur H1. La sortie de l'intégrateur H1 est reliée à l'entrée de l'intégrateur H2 par l'intermédiaire d'un multiplicateur 311 par un coefficient b. La sortie de l'intégrateur H1 est en outre reliée à une première entrée positive d'un circuit de sommation/soustraction 312 par l'intermédiaire d'un multiplicateur 313 par un coefficient c. La sortie de l'intégrateur H2 est reliée à une deuxième entrée positive du circuit de sommation/soustraction 312. Le modulateur M comprend en outre un premier convertisseur analogique numérique 1-bit 315 dont l'entrée est reliée à la sortie du circuit de sommation/soustraction 312. Le convertisseur 1 bit 315 est représenté sous la forme d'un sommateur ajoutant au signal de sortie du circuit 312 un bruit de quantification E1 introduit par le convertisseur 315. Le modulateur M comprend en outre un soustracteur 317 réalisant la différence entre la sortie et l'entrée du convertisseur 1-bit 315. Le signal d'erreur de quantification ainsi généré est appliqué à l'entrée positive d'un autre soustracteur 319 dont la sortie est reliée à l'entrée de l'intégrateur H3. La sortie de l'intégrateur H3 est reliée à l'entrée d'un deuxième convertisseur analogique numérique 1-bit 321. Le convertisseur 1 bit 321 est représenté sous la forme d'un sommateur ajoutant au signal de sortie de l'intégrateur H3 un bruit de quantification E2. Le modulateur M comprend en outre une boucle de rétroaction reliant la sortie du convertisseur 1 bit 321 à l'entrée négative du soustracteur 319 par l'intermédiaire d'un multiplicateur 323 par un coefficient 1+α3. Le modulateur M comprend de plus un opérateur de retard 324 à gain unitaire noté $Z^{-1}$, dont l'entrée est reliée à la sortie du convertisseur 1 bit 315, et un soustracteur 325 dont l'entrée positive est reliée à la sortie de l'opérateur de retard 324 et dont l'entrée négative est reliée à la sortie du convertisseur 1 bit 321. La sortie du soustracteur 325 forme la sortie du modulateur M. La sortie du soustracteur 325 est en outre reliée à l'entrée négative du soustracteur 108, et à une entrée négative du circuit de sommation/soustraction 312 par l'intermédiaire d'un multiplicateur 327 par un coefficient d. Les coefficients b, c et d sont des coefficients d'ajustement de la STF et de la NTF, par exemple régis par les équations suivantes :

$$b = c*(1+\alpha2) - d*(1+\alpha1)*(1+\alpha2)$$

$$c = d^2 - (1+\alpha1)*(1+\alpha2)$$

$$d = 2 + \alpha1 + \alpha2$$

Le filtre numérique F comprend trois étages d'intégration numérique cascadés et1, et2, et3. Chaque étage comprend, comme dans l'exemple de la figure 18, un sommateur 303, un opérateur à retard 305 à gain unitaire, noté $Z^{-1}$, et un multiplicateur 307. Une première entrée du sommateur 303 est reliée à l'entrée de l'étage. La sortie du sommateur 303 est reliée à l'entrée de l'opérateur 305. La sortie de l'opérateur 305 est reliée à la sortie de l'étage. Le multiplicateur 307 relie la sortie de l'opérateur 305 à une deuxième entrée du sommateur 303. L'entrée de l'étage et1 est reliée à la sortie du modulateur M, la sortie de l'étage et1 est reliée à l'entrée de l'étage et2, la sortie de l'étage et2 est reliée à l'entrée de l'étage et3, et la sortie de l'étage et3 est reliée à la sortie du filtre F. Les multiplicateurs 307 des étages et1, respectivement et2, respectivement et3, appliquent des coefficients de multiplication $1+\alpha1$, respectivement $1+\alpha2$, respectivement $1+\alpha3$.

On désigne ici par U le signal d'entrée du modulateur M appliqué sur la borne d'entrée positive du soustracteur 108, par Y le signal de sortie du modulateur M fourni en sortie du soustracteur 325 et par W le signal de sortie du filtre numérique F.

Les signaux Y et W peuvent s'exprimer par les relations suivantes :

$$Y = z^{-2}U\left(c + z^{-1}\big(b - c(1 + \alpha2)\big)\right)$$
$$- E2(1 - (1 + \alpha1)z^{-1})(1 - (1 + \alpha2)z^{-1})(1 - (1 + \alpha3)z^{-1})$$
$$+ z^{-1}N1\left(c + z^{-1}\big(b - c(1 + \alpha2)\big)\right) + z^{-1}N2(1 - (1 + \alpha1)z^{-1})$$
$$- N3(1 - (1 + \alpha1)z^{-1})(1 - (1 + \alpha2)z^{-1})$$

$$W \sim \frac{z^{-6}U}{(1 - (1 + \alpha1)z^{-1})(1 - (1 + \alpha2)z^{-1})(1 - (1 + \alpha3)z^{-1})} - z^{-3}E2$$

$$+ \frac{z^{-5}N1}{(1 - (1 + \alpha1)z^{-1})(1 - (1 + \alpha2)z^{-1})(1 - (1 + \alpha3)z^{-1})}$$

$$+ \frac{z^{-4}N2}{(1 - (1 + \alpha2)z^{-1})(1 - (1 + \alpha3)z^{-1})} + \frac{z^{-3}N3}{(1 - (1 + \alpha3)z^{-1})}$$

On peut voir d'après l'expression de W que la contribution majoritaire de bruit sera liée à N1. Ainsi, le coefficient $\alpha1$ est de préférence choisi non nul, les coefficients $\alpha2$ et $\alpha3$ pouvant éventuellement être nuls pour simplifier la réalisation du convertisseur. En choisissant des durées de cycles plus longues en début de phase de conversion, puis plus courtes par la suite, la bande passante de l'intégrateur H1 pour le bruit N1 peut être réduite en début de conversion, puis augmentée par la suite, de façon à réduire la contribution totale du bruit N1 dans la valeur de sortie numérique finale du convertisseur.

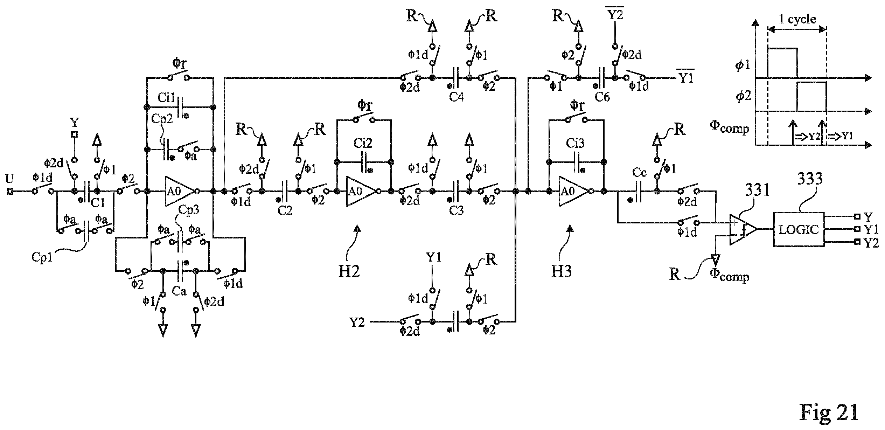

La figure 21 est un schéma électrique détaillé illustrant un exemple de réalisation du modulateur M du convertisseur de la figure 20. Dans cet exemple, le coefficient $\alpha1$ est non nul, et les coefficients $\alpha2$ et $\alpha3$ sont nuls.

Dans l'exemple de la figure 21, chaque intégrateur Hj (avec j allant de 1 à 3) comprend un amplificateur opérationnel AO dont l'entrée est reliée à la sortie par une capacité d'intégration Cij. L'entrée et la sortie de l'amplificateur opérationnel forment respectivement l'entrée et la sortie de l'intégrateur. Chaque intégrateur Hj comprend en outre, en parallèle de sa capacité d'intégration Cij, un interrupteur de réinitialisation $\Phi r$. Chaque intégrateur Hj a son entrée reliée à une première électrode d'une capacité Cj par un interrupteur $\Phi 2$. Chaque capacité Cj a en outre sa première électrode reliée à un noeud R d'application d'une tension de référence par un interrupteur $\Phi 1$. La capacité C1 a sa deuxième électrode reliée d'une part à une borne d'application du signal d'entrée U du modulateur par un interrupteur $\Phi 1d$ et d'autre part à une borne de fourniture du signal Y (signal de sortie du soustracteur 325 de la figure 20) par un interrupteur $\Phi 2d$. Chacune des capacités C2 et C3 a sa deuxième électrode reliée d'une part à la sortie de l'intégrateur de rang précédent (j-1) par un interrupteur $\Phi 1d$, et d'autre part au noeud R par un interrupteur $\Phi 2d$. Le modulateur de la figure 21 comprend en outre une capacité Ca dont une première électrode est reliée d'une part à l'entrée de l'intégrateur H1 par un interrupteur $\Phi 2$ et d'autre part au noeud R par un interrupteur $\Phi 1$, et dont la deuxième électrode est reliée d'une part à la sortie de l'interrupteur H1 par un interrupteur $\Phi 1d$ et d'autre part au noeud R par un interrupteur $\Phi 2d$. Le modulateur comprend de plus une capacité C5 dont une première électrode est reliée d'une part à l'entrée de l'intégrateur H3 par un interrupteur $\Phi 2$ et d'autre part au noeud R par un interrupteur $\Phi 1$, et dont la deuxième électrode est reliée d'une part à un noeud Y1 correspondant à l'entrée de l'opérateur 324 par un interrupteur $\Phi 1d$ et d'autre part à un noeud Y2 correspondant à l'entrée négative du soustracteur 325 par un interrupteur $\Phi 2d$. Le modulateur comprend en outre une capacité C4 dont une première électrode est reliée d'une part à la sortie de l'intégrateur H1 par un interrupteur $\Phi 2d$ et d'autre part au noeud R par un interrupteur $\Phi 1d$, et dont la deuxième électrode est reliée d'une part à l'entrée de l'intégrateur H3 par un interrupteur $\Phi 2$ et d'autre part au noeud R par un interrupteur $\Phi 1$. Le modulateur comprend en outre une capacité C6 dont une première électrode est reliée d'une part à l'entrée de l'intégrateur H3 par un interrupteur $\Phi 1$ et d'autre part au noeud R par un interrupteur $\Phi 2$, et dont la deuxième électrode est reliée d'une part à un noeud $\overline{Y1}$ de fourniture d'un signal complémentaire du signal Y1 par un interrupteur $\Phi 1d$, et d'autre part à un noeud $\overline{Y2}$ de fourniture d'un signal complémentaire du signal Y2 par un interrupteur $\Phi 2d$. Le modulateur comprend de plus une capacité Cc dont une première électrode est connectée à la sortie de l'intégrateur H3 et dont la deuxième électrode est reliée au noeud R par l'intermédiaire d'un interrupteur $\Phi 1$. Le modulateur comprend en outre un comparateur 331 dont une entrée (+) est reliée d'une part à la première électrode de la capacité Cc par un interrupteur $\Phi 1d$ et d'autre part à la deuxième électrode de la capacité Cc par un interrupteur $\Phi 2d$. Dans cet exemple, la deuxième entrée (-) du comparateur 331 est connectée au noeud R. La sortie du comparateur 331 est reliée à un circuit logique 333 (LOGIC) adapté à fournir les signaux Y, Y1 et Y2. Le modulateur de la figure 21 comprend par ailleurs une capacité cp1 dont les première et deuxième électrodes sont reliées respectivement aux première et deuxième électrodes de la capacité C1 par des premier et deuxième interrupteurs $\Phi a$, une capacité cp2 dont la première électrode est connectée à l'entrée de l'intégrateur H1 et dont la deuxième électrode est reliée à la sortie de l'intégrateur H2 par un interrupteur $\Phi a$, et une capacité cp3 dont les première et deuxième électrodes sont reliées respectivement aux première et deuxième électrodes de la capacité Ca par des premier et deuxième interrupteurs $\Phi a$. Bien que les interrupteurs commutant les capacités C1, C2, C3, C4, C5, C6, Ca, Cc, Cp1, Cp2, Cp3 soient différents, des mêmes appellations sont utilisées pour les interrupteurs commutés simultanément.

On retrouve dans cette architecture dite SMASH 2-1 un modulateur d'ordre 2 formé par l'association en série des intégrateurs H1 et H2, et un modulateur d'ordre 1 formé par l'intégrateur H3. Le sommateur du modulateur d'ordre 2 est ici implémenté de manière conjointe avec l'intégrateur H3 du modulateur d'ordre 1. Ainsi, la quantification de la sommation en sortie du modulateur d'ordre 2 est effectuée à partir de la dérivée de l'intégrateur H3 du modulateur d'ordre 1. En effet, l'intégrateur H3 reçoit pour entrée l'erreur de quantification E1 du premier modulateur, à laquelle est soustraite la contre-réaction Y2. Comme l'illustre un chronogramme sur la figure 21, chaque cycle de fonctionnement du modulateur peut se décomposer en deux étapes, une étape (phase $\Phi 2$) d'intégration négative des signaux de sortie des deux premiers intégrateurs H1 et H2 et de la contreréaction Y, avec quantification de la sortie au travers de la capacité de couplage Cc (permettant la mise à jour de Y1), suivie d'une étape (phase $\Phi 1$) d'intégration de la différence Y1-Y2 avec quantification de la sortie de l'intégrateur pour mettre à jour le signal Y2. Un avantage de l'implémentation de la figure 21 est qu'elle n'utilise qu'un seul comparateur. Dans cet exemple, le paramètre $\alpha 1 > 0$ est intégré au sein de l'intégrateur H1 par le biais d'une contre-réaction positive réalisée à l'aide de la capacité Ca dont la valeur est choisie telle que le ratio Ca/Ci1 soit égal à $\alpha 1$. Les interrupteurs $\Phi a$ permettent, lorsqu'ils sont commandés à l'état passant, d'augmenter les valeurs équivalentes des capacités C1, respectivement Ci1, respectivement Ca, des valeurs Cp1, respectivement Cp2, respectivement Cp3, ce qui permet de mettre en oeuvre un mode de commande dans lequel la bande passante de l'intégrateur H1 est réduite et où les durées des phases de commande $\Phi 1$, $\Phi 1d$, $\Phi 2$, $\Phi 2d$ sont augmentées proportionnellement. De façon similaire, on peut faire varier la puissance de bruit dans les différents noeuds du modulateur en jouant sur les bandes d'intégration des bruits concernés, par le biais de plusieurs jeux de capacités.

## Revendications

1. Convertisseur sigma-delta adapté à mettre en oeuvre une phase de conversion d'un signal analogique d'entrée (Vin) en une valeur numérique de sortie (Sd), la phase de conversion comportant une pluralité de cycles de fonctionnement, le convertisseur comportant un modulateur sigma-delta comportant au moins un filtre analogique (106, H1, H2, H3) adapté, à chaque cycle de la phase de conversion, à recevoir un signal analogique interne issu du signal analogique d'entrée (Vin) et à fournir une valeur analogique de sortie, dans lequel :

   la contribution du signal analogique interne à la valeur de sortie du filtre analogique est plus faible à un cycle (k) donné de la phase de conversion qu'à un cycle précédent (k-1) de la phase de conversion, les contributions aux différents cycles étant régies par une première loi (f(k)) prédéterminée fonction du rang (k) du cycle dans la phase de conversion ; et
   la durée d'un cycle (k) donné de la phase de conversion est inférieure à la durée d'un cycle précédent (k-1) de la phase de conversion, les durées des différents cycles étant régies par une deuxième loi (Tc(k)) prédéterminée fonction du rang (k) du cycle dans la phase de conversion.

2. Convertisseur sigma-delta selon la revendication 1, dans lequel la deuxième loi (Tc(k)) est décroissante sur toute la durée de la phase de conversion.

3. Convertisseur sigma-delta selon la revendication 2, dans lequel la deuxième loi (Tc(k)) est décroissante par paliers.

4.  Convertisseur sigma-delta selon l'une quelconque des revendications 1 à 3, dans lequel ledit au moins un filtre analogique (106 ; H1, H2, H3) comprend au moins une capacité d'intégration (Cfb ; Ci1) de valeur réglable.

5.  Convertisseur sigma-delta selon la revendication 4, dans lequel, pendant la phase de conversion, la valeur de ladite capacité d'intégration varie proportionnellement à la durée des cycles.

6.  Convertisseur sigma-delta selon l'une quelconque des revendications 1 à 5, dans lequel le modulateur comporte plusieurs filtres analogiques (H1, H2, H3).

7.  Convertisseur sigma-delta selon la revendications 6, dans lequel lesdits filtres analogiques (H1, H2, H3) forment plusieurs chaines d'un ou plusieurs filtres cascadés, les sorties desdites chaines étant combinées pour générer un signal de sortie du modulateur.

8.  Convertisseur sigma-delta selon la revendication 7, comportant un unique convertisseur analogique-numérique 1-bit (331).

9.  Convertisseur sigma-delta selon l'une quelconque des revendications 1 à 8, comprenant en entrée du filtre un dispositif de pondération (C1 à C4 ; $CP_1$ à $CP_7$) du signal analogique interne reçu par le filtre analogique appliquant un coefficient de pondération variable $\beta k$, fonction du rang k du cycle et dans lequel, durant la phase de conversion, au moins deux coefficients distincts $\beta k-1$ et $\beta k$ sont appliqués, respectivement pour deux cycles successifs de rang k-1 et k, et dans lequel $\beta k-1 > \beta k$.

10. Convertisseur sigma-delta selon la revendication 9, dans lequel le coefficient de pondération variable $\beta k$ est décroissant avec le rang k du cycle.

11. Convertisseur selon l'une quelconque des revendications 1 à 10, dans lequel ledit au moins un filtre analogique est équivalent à un circuit théorique comprenant un sommateur entre la valeur d'un signal analogique reçu au cycle k et un signal interne du filtre correspondant à une multiplication par un coefficient $1+\alpha$ du signal de sortie du filtre analogique obtenu au cycle k-1, et dans lequel, durant la phase de conversion, au moins une valeur du coefficient $\alpha$ supérieure strictement à zéro est appliquée pour au moins un cycle.

12. Convertisseur selon la revendication 11, dans lequel le coefficient $\alpha$ est croissant avec le rang k du cycle.

Fig 1A

Fig 1B

Fig 3

Fig 2

Fig 4

Fig 5A

Fig 5B

Fig 6

Fig 7

Fig 8

Fig 9

Fig 10

Fig 11

Fig 12

Fig 13

Fig 14

Fig 15a

Fig 15b

Fig 16

$T_{CONV}$

| Tc | Tc | Tc | | Tc | Tc |
|---|---|---|---|---|---|

| Cycle 1 | Cycle 2 | Cycle 3 | . . . | Cycle OSR-1 | Cycle OSR |
|---|---|---|---|---|---|

| Tc(1) | Tc(2) | Tc(3) | | Tc(OSR-1) | Tc(OSR) |
|---|---|---|---|---|---|

| Cycle 1 | Cycle 2 | Cycle 3 | . . . |
|---|---|---|---|

Cycle OSR-1

Cycle OSR

**Fig 17**

M

101

106

108   109   111   N1   301   E1   303   305

U   A1                z⁻¹        V                z⁻¹   W

$1+\alpha$   113   A3   103   A2   307   $1+\alpha$

1 bit
DAC

A4

107

F

**Fig 18**

Fig 19

Fig 20

Fig 21

Europäisches
Patentamt

European
Patent Office

Office européen
des brevets

**RAPPORT DE RECHERCHE EUROPEENNE**

Numéro de la demande

EP 17 18 0146

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | DE 197 25 171 A1 (BOSCH GMBH ROBERT [DE]) 17 décembre 1998 (1998-12-17) * colonne 2; revendication 1; figure 1 * | 1-12 | INV. H03M3/00 |
| X | US 7 053 807 B1 (GAALAAS ERIC [US]) 30 mai 2006 (2006-05-30) * colonnes 2,3,6; revendications 1,3; figures 1,3 * | 1-12 | |
| X | ZOURNTOS T ET AL: "STABLE ONE-BIT DELTA-SIGMA MODULATORS BASED ON SWITCHING CONTROL", PROCEEDINGS OF THE 1998 IEEE INTERNATIONAL CONFERENCE ON ACOUSTICS, SPEECH AND SIGNAL PROCESSING. ICASSP '98. SEATTLE, WA, MAY 12 - 15, 1998; [IEEE INTERNATIONAL CONFERENCE ON ACOUSTICS, SPEECH AND SIGNAL PROCESSING], NEW YORK, NY : IEEE, US, vol. CONF. 23, 12 mai 1998 (1998-05-12), pages 1597-1600, XP000948407, DOI: 10.1109/ICASSP.1998.681758 ISBN: 978-0-7803-4429-7 * Section 1; Section 2; figures 2-4 * | 1-12 | |
| A | Libin Yao ET AL: "A High-Linearity Sigma-Delta Topology Suitable for Low-Voltage Applications", , 1 janvier 2000 (2000-01-01), XP055239216, Extrait de l'Internet: URL:http://citeseerx.ist.psu.edu/viewdoc/download;jsessionid=9C31627DB868C831BFCBCC76F0E7E6E8?doi=10.1.1.6.2988&rep=rep1&type=pdf [extrait le 2016-01-07] * Section III; figure 3 * | 1-12 | |

DOMAINES TECHNIQUES RECHERCHES (IPC)

H03M

-/--

Le présent rapport a été établi pour toutes les revendications

| Lieu de la recherche | Date d'achèvement de la recherche | Examinateur |
|---|---|---|
| La Haye | 28 novembre 2017 | Jesus, Paulo |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 17 18 0146

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 5 241 310 A (TIEMANN JEROME J [US]) 31 août 1993 (1993-08-31) * colonnes 2,3; figures 2-3 * | 1-12 | |
| A | US 8 405 535 B1 (XIAO PING [US] ET AL) 26 mars 2013 (2013-03-26) * colonnes 6-9; figures 5-8,10 * | 1-12 | |
| A | US 2009/289824 A1 (CHEN KUO-HSIN [TW]) 26 novembre 2009 (2009-11-26) * alinéas [0020] - [0021]; figures 1-4 * | 1-12 | |
| A | XIAOCHU XU ET AL: "VARIABLE-SAMPLING-RATE SIGMA-DELTA MODULATOR FOR INSTRUMENTATION AND MEASUREMENT", IEEE TRANSACTIONS ON INSTRUMENTATION AND MEASUREMENT, IEEE SERVICE CENTER, PISCATAWAY, NJ, US, vol. 44, no. 5, 1 octobre 1995 (1995-10-01), pages 929-932, XP000535998, ISSN: 0018-9456, DOI: 10.1109/19.414502 * Section III; figures 2-3 * | 1-12 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 28 novembre 2017 | Jesus, Paulo |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

   .................................................................
& : membre de la même famille, document correspondant

EPO FORM 1503 03.82 (P04C02)

EP 3 276 833 A1

**ANNEXE AU RAPPORT DE RECHERCHE EUROPEENNE
RELATIF A LA DEMANDE DE BREVET EUROPEEN NO.**

EP 17 18 0146

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-11-2017

| Document brevet cité au rapport de recherche | | | Date de publication | Membre(s) de la famille de brevet(s) | | Date de publication |
|---|---|---|---|---|---|---|
| DE 19725171 | A1 | | 17-12-1998 | AUCUN | | |
| US 7053807 | B1 | | 30-05-2006 | CN US | 1893281 A 7053807 B1 | 10-01-2007 30-05-2006 |
| US 5241310 | A | | 31-08-1993 | AUCUN | | |
| US 8405535 | B1 | | 26-03-2013 | AUCUN | | |
| US 2009289824 | A1 | | 26-11-2009 | TW US | 200950352 A 2009289824 A1 | 01-12-2009 26-11-2009 |

EPO FORM P0460

Pour tout renseignement concernant cette annexe : voir Journal Officiel de l'Office européen des brevets, No.12/82

39

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **KUO, T.H. ; CHEN, K.D. ; CHEN, J.R.** Automatic co-efficients design for high-order sigma-delta modulators. *Circuits and Systems II: Analog and Digital Signal Processing, IEEE Transactions,* vol. 46 (1

- Understanding Delta-Sigma Data Converters. John Wiley & Sons, 2004